# EUROPEAN PATENT APPLICATION

(11) **EP 4 693 405 A1**
(43) Date of publication of application: **11.02.2026**
(21) Application number: 24778891.2
(22) Date of filing: 22.02.2024
(51) Int. Cl.: H01L 27/146, H04N 25/70, H04N 25/77

(54) **LIGHT DETECTION DEVICE AND ELECTRONIC DEVICE**

(30) Priority: 31.03.2023 JP 2023058821
(71) Applicant: Sony Semiconductor Solutions Corporation, Atsugi-shi, Kanagawa 243-0014 (JP)
(72) Inventor: TAKAYANAGI, Ryohei, Atsugi-shi, Kanagawa 243-0014 (JP); KAMETANI, Machiko, Atsugi-shi, Kanagawa 243-0014 (JP); YAMAMOTO, Atsuhiko, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/006413
(87) International publication number: WO 2024/202748

(57) **Abstract**

A photodetector according to an embodiment of the disclosure includes a first photoelectric conversion element, a first readout circuit, a second photoelectric conversion element, a second readout circuit, and an electric conductor. The first photoelectric conversion element photoelectrically converts light. The first readout circuit includes a first transistor provided on a side of a first surface of a first semiconductor layer, and is configured to output a first signal based on electric charge obtained by conversion by the first photoelectric conversion element. The second photoelectric conversion element photoelectrically converts light. The second readout circuit includes a second transistor provided next to the first transistor on the side of the first surface of the first semiconductor layer, and is configured to output a second signal based on electric charge obtained by conversion by the second photoelectric conversion element. The electric conductor is provided between the first transistor and the second transistor.

## Description

### Technical Field

This disclosure relates to a photodetector and an electronic apparatus.

### Background Art

An imaging device has been proposed which includes a first substrate on which photodiodes are provided and a second substrate on which pixel circuits are provided (see PTL 1).

### Citation List

### Patent Literature

PTL 1: International Publication No. WO2022/138914

### Summary of the Invention

For devices that detect light, there has been a demand for minimizing the degradation of signal quality.

It is desirable to provide a photodetector that enables suppression of the degradation of signal quality.

A photodetector according to an embodiment of the present disclosure includes a first photoelectric conversion element, a first readout circuit, a second photoelectric conversion element, a second readout circuit, and an electric conductor. The first photoelectric conversion element photoelectrically converts light. The first readout circuit includes a first transistor provided on a side of a first surface of a first semiconductor layer, the first readout circuit being configured to output a first signal based on electric charge obtained by conversion by the first photoelectric conversion element. The second photoelectric conversion element photoelectrically converts light. The second readout circuit includes a second transistor provided next to the first transistor on the side of the first surface of the first semiconductor layer, the second readout circuit being configured to output a second signal based on electric charge obtained by conversion by the second photoelectric conversion element. The electric conductor is provided between the first transistor and the second transistor.

A photodetector according to an embodiment of the present disclosure includes a first photoelectric conversion element, a first readout circuit, a second photoelectric conversion element, a second readout circuit, and an insulator. The first photoelectric conversion element photoelectrically converts light. The first readout circuit includes a first transistor provided on a side of a first surface of a first semiconductor layer, the first readout circuit being configured to output a first signal based on electric charge obtained by conversion by the first photoelectric conversion element. The second photoelectric conversion element photoelectrically converts light. The second readout circuit includes a second transistor provided next to the first transistor on the side of the first surface of the first semiconductor layer, the second readout circuit being configured to output a second signal based on electric charge obtained by conversion by the second photoelectric conversion element. The insulator is provided, in the first semiconductor layer, between the first transistor and the second transistor.

An electronic apparatus according to an embodiment of the present invention includes an optical system and a photodetector. The photodetector receives light transmitted through the optical system, in which the photodetector includes a first photoelectric conversion element that photoelectrically converts light, a first readout circuit including a first transistor provided on a side of a first surface of a first semiconductor layer, the first readout circuit being configured to output a first signal based on electric charge obtained by conversion by the first photoelectric conversion element, a second photoelectric conversion element that photoelectrically converts light, a second readout circuit including a second transistor provided next to the first transistor on the side of the first surface of the first semiconductor layer, the second readout circuit being configured to output a second signal based on electric charge obtained by conversion by the second photoelectric conversion element, and an electric conductor provided between the first transistor and the second transistor.

### Brief Description of the Drawings

[FIG. 1] FIG. 1 is a block diagram illustrating an example of the schematic configuration of an imaging device which is an example of a photodetector according to a first embodiment of the present disclosure.
[FIG. 2] FIG. 2 is a diagram illustrating an example of a pixel section of an imaging device according to the first embodiment of the present disclosure.
[FIG. 3] FIG. 3 is a diagram for explaining an example of the circuit configuration of a pixel of the imaging device according to the first embodiment of the present disclosure.
[FIG. 4] FIG. 4 is a diagram illustrating an example of the cross-sectional configuration of the imaging device according to the first embodiment of the present disclosure.
[FIG. 5A] FIG. 5A is a diagram illustrating an example of the planar configuration of the imaging device according to the first embodiment of the present disclosure.
[FIG. 5B] FIG. 5B is a diagram illustrating an example of the planar configuration of the imaging device according to the first embodiment of the present disclosure.
[FIG. 5C] FIG. 5C is a diagram for explaining an example of the cross-sectional configuration of a pixel of the imaging device according to the first embodiment of the present disclosure.
[FIG. 5D] FIG. 5D is a diagram for explaining another example of the cross-sectional configuration of a pixel of the imaging device according to the first embodiment of the present disclosure.
[FIG. 5E] FIG. 5E is a diagram for explaining another example of the cross-sectional configuration of a pixel of the imaging device according to the first embodiment of the present disclosure.
[FIG. 5F] FIG. 5F is a diagram for explaining another example of the cross-sectional configuration of a pixel of the imaging device according to the first embodiment of the present disclosure.
[FIG. 5G] FIG. 5G is a diagram for explaining another example of the cross-sectional configuration of a pixel of the imaging device according to the first embodiment of the present disclosure.
[FIG. 6A] FIG. 6A is a diagram for explaining an example of the configuration of an imaging device according to Modification 1 of the present disclosure.
[FIG. 6B] FIG. 6B is a diagram for explaining another example of the configuration of the imaging device according to Modification 1 of the present disclosure.
[FIG. 7] FIG. 7 is a diagram for explaining an example of the configuration of an imaging device according to Modification 2 of the present disclosure.
[FIG. 8A] FIG. 8A is a diagram for explaining an example of the configuration of an imaging device according to Modification 3 of the present disclosure.
[FIG. 8B] FIG. 8B is a diagram for explaining an example of the configuration of an imaging device according to Modification 3 of the present disclosure.
[FIG. 9] FIG. 9 is a diagram for explaining an example of the configuration of an imaging device according to Modification 4 of the present disclosure.
[FIG. 10] FIG. 10 is a diagram for explaining an example of the configuration of an imaging device according to Modification 5 of the present disclosure.
[FIG. 11] FIG. 11 is a diagram for explaining an example of the configuration of an imaging device according to Modification 6 of the present disclosure.
[FIG. 12] FIG. 12 is a diagram for explaining another example of the configuration of an imaging device according to Modification 6 of the present disclosure.
[FIG. 13] FIG. 13 is a diagram for explaining another example of the configuration of an imaging device according to Modification 6 of the present disclosure.
[FIG. 14] FIG. 14 is a diagram for explaining an example of the configuration of an imaging device according to Modification 7 of the present disclosure.
[FIG. 15] FIG. 15 is a diagram for explaining an example of the configuration of an imaging device according to Modification 8 of the present disclosure.
[FIG. 16] FIG. 16 is a diagram for explaining an example of the configuration of an imaging device according to Modification 9 of the present disclosure.
[FIG. 17] FIG. 17 is a diagram illustrating an example of the cross-sectional configuration of an imaging device according to a second embodiment of the present disclosure.
[FIG. 18] FIG. 18 is a diagram for explaining an example of the configuration of the imaging device according to the second embodiment of the present disclosure.
[FIG. 19] FIG. 19 is a diagram for explaining an example of the configuration of the imaging device according to the second embodiment of the present disclosure.
[FIG. 20] FIG. 20 is a diagram for explaining an example of the configuration of the imaging device according to the second embodiment of the present disclosure.
[FIG. 21] FIG. 21 is a diagram for explaining an example of the configuration of the imaging device according to the second embodiment of the present disclosure.
[FIG. 22A] FIG. 22A is a diagram for explaining an example of the configuration of the imaging device according to Modification 10 of the present disclosure.
[FIG. 22B] FIG. 22B is a diagram for explaining an example of the configuration of the imaging device according to Modification 10 of the present disclosure.
[FIG. 23] FIG. 23 is a diagram illustrating an example of the cross-sectional configuration of an imaging device according to a third embodiment of the present disclosure.
[FIG. 24A] FIG. 24A is a diagram for explaining an example of the configuration of the imaging device according to the third embodiment of the present disclosure.
[FIG. 24B] FIG. 24B is a diagram for explaining an example of the configuration of the imaging device according to the third embodiment of the present disclosure.
[FIG. 25A] FIG. 25A is a diagram for explaining another example of the configuration of the imaging device according to the third embodiment of the present disclosure.
[FIG. 25B] FIG. 25B is a diagram for explaining another example of the configuration of the imaging device according to the third embodiment of the present disclosure.
[FIG. 26] FIG. 26 is a block diagram illustrating a configuration example of an electronic apparatus including the imaging device.
[FIG.27] FIG. 27 is a block diagram depicting an example of schematic configuration of a vehicle control system.
[FIG.28] FIG. 28 is a diagram of assistance in explaining an example of installation positions of an outside-vehicle information detecting section and an imaging section.
[FIG.29] FIG. 29 is a view depicting an example of a schematic configuration of an endoscopic surgery system.
[FIG.30] FIG. 30 is a block diagram depicting an example of a functional configuration of a camera head and a camera control unit (CCU).

### Modes for Carrying Out the Invention

Embodiments of the present disclosure will be described in detail below with reference to the accompanying drawings. Note that the description will be given in the following order.
1. First Embodiment
2. Second Embodiment
3. Third Embodiment
4. Application Example
5. Practical Application Examples

### <1. First Embodiment>

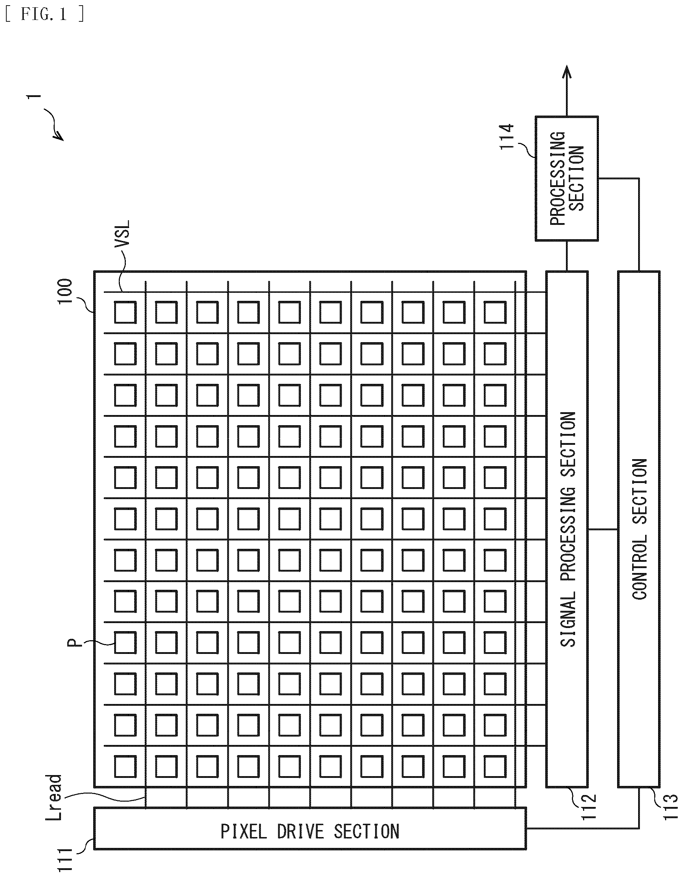

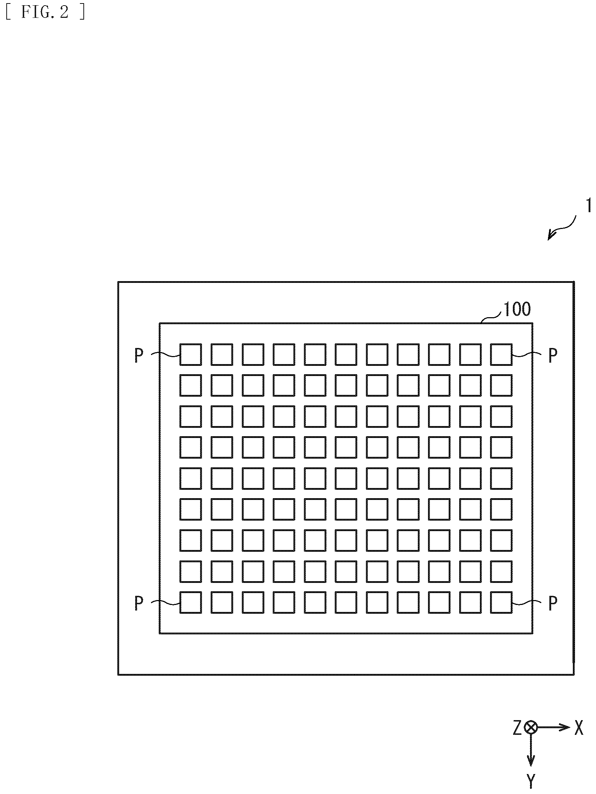

FIG. 1 is a block diagram illustrating an example of the schematic configuration of an imaging device which is an example of a photodetector according to a first embodiment of the present disclosure. FIG. 2 is a diagram illustrating an example of a pixel section of an imaging device according to the first embodiment of the present disclosure. An imaging device 1, which is a photodetector, includes a plurality of pixels P including a photoelectric conversion section (photoelectric conversion element) and is configured to generate signals by photoelectrically converting entering light. The imaging device 1 (photodetector) may receive light transmitted through an optical system (not illustrated in the drawings) including an optical lens, and generate a signal.

The imaging device 1 includes, for example, a semiconductor substrate (e.g., a silicon substrate) on which a plurality of pixels P are provided. The photoelectric conversion section of each pixel P of the imaging device 1 is, for example, a photodiode (PD), and is configured to photoelectrically convert light. As illustrated in FIG. 2, the imaging device 1 includes a region (pixel section 100) in which a plurality of pixels P are disposed in a two-dimensional matrix as an imaging area. The pixel section 100 is a pixel array in which a plurality of pixels P are disposed, and may also be referred to as a light-receiving region.

The imaging device 1 takes entering light (image light) from a subject through an optical system that includes an optical lens. The imaging device 1 captures the image of the subject formed by the optical lens. The imaging device 1 may generate pixel signals by photoelectrically converting the received light. The imaging device 1 is, for example, a complementary metal oxide semiconductor (CMOS) image sensor. It is possible to use the imaging device 1, for example, in an electronic apparatus, such as digital still cameras, video cameras, and cell phones.

Note that as illustrated in FIG. 2, the direction of light entering from the subject is the Z-axis direction, the left and right directions to the viewer orthogonal to the Z-axis direction are the X-axis direction, and the vertical direction to the viewer orthogonal to the Z-axis and X-axis directions are the Y-axis direction. In relation to the following drawings, directions may be indicated with reference to the directions of the arrows illustrated in FIG. 2.

As illustrated in the example illustrated in FIG. 1, the imaging device 1 includes, for example, a pixel drive section 111, a signal processing section 112, a control section 113, and a processing section 114 in the peripheral region of the pixel section 100 (pixel array). The imaging device 1 is also provided with a plurality of control lines Lread and a plurality of signal lines VSL.

The control lines Lread are signal lines that make it possible to convey signals to control the pixels P, and is coupled to the pixel drive section 111 and the pixels P in the pixel section 100. In the example illustrated in FIG. 1, in the pixel section 100, a plurality of control lines Lread are wired for each pixel row which includes a plurality of pixels P aligned in the horizontal direction (row direction). The control lines Lread are configured to transmit control signals for readout of signals from the pixels P.

The plurality of control lines Lread for each pixel row of the imaging device 1 include, for example, wiring that transmits a signal to control the transfer transistor, wiring that transmits a signal to control the selection transistor, and wiring that transmits a signal to control the reset transistor. The control lines Lread may also be referred to as drive lines (pixel drive section lines) that transmit signals to drive the pixels P.

The signal lines VSL are signal lines that make it possible to transmit signals from the pixels P and are coupled to the pixels P of the pixel section 100 and to the signal processing section 112. In the pixel section 100, for example, one or more signal lines VSL are wired for each pixel column including a plurality of pixels P aligned in the vertical direction (column direction).

The signal lines VSL are vertical signal lines and are configured to transmit signals output from the pixels P. In the imaging device 1, a plurality of signal lines VSL may be provided for one pixel column. The imaging device 1 may include a plurality of signal lines VSL for each pixel column.

The pixel drive section 111 is configured to drive each pixel P of the pixel section 100. The pixel drive section 111 is a drive circuit and includes a plurality of circuits including, for example, a buffer, a shift register, and an address decoder. The pixel drive section 111 generates signals to drive the pixels P and outputs them to each pixel P of the pixel section 100 via the control line Lread. The pixel drive section 111 is controlled by the control section 113 and controls the pixels P of the pixel section 100.

The pixel drive section 111 generates signals to control the pixels P, for example, signals to control the transfer transistors of the pixels P, signals to control the selection transistors of the pixels P, and signals to control the reset transistors of the pixels P, and supplies them to each pixel P via the control line Lread. The pixel drive section 111 may control the readout of pixel signals from each pixel P. The pixel drive section 111 may also be referred to as a pixel control section configured to control each pixel P. Note that the pixel drive section 111 and the control section 113 may also be collectively referred to as a pixel control section.

The signal processing section 112 is configured to perform signal processing of the input signals from the pixels. The signal processing section 112 is a signal processing circuit and includes, for example, a load circuit, an analog digital (AD) converter, and a horizontal selection switch. Note that the signal processing section 112 may include an amplification circuit configured to amplify signals read out from the pixels P via the signal lines VSL.

The signals output from each pixel P, which are selectively scanned by the pixel drive section 111, are input to the signal processing section 112 via the signal lines VSL. The signal processing section 112 may perform, for example, signal processing such as AD conversion and correlated double sampling (CDS) of the signals from the pixels P. The signal from each pixel P transmitted via the corresponding signal line VSL is signal-processed in the signal processing section 112 and output to the processing section 114.

The processing section 114 is configured to perform signal processing on the input signals. The processing section 114 is a signal processing circuit and includes, for example, a circuit that performs various types of signal processing on the pixel signals. The processing section 114 may include a processor and a memory. The processing section 114 performs signal processing on the pixel signals input from the signal processing section 112 and outputs the pixel signals after processing. The processing section 114 may, for example, perform various types of signal processing, such as noise reduction processing or gray-scale correction processing.

The control section 113 is configured to enable the components of the imaging device 1 to be controlled. The control section 113 may receive clocks, data commanding the operation mode, and other data provided from the exterior, and output data such as internal information associated with the imaging device 1. The control section 113 is a control circuit and includes, for example, a timing generator configured to generate various timing signals.

The control section 113 performs drive control of, for example, the pixel drive section 111 and the signal processing section 112, in accordance with various timing signals (e.g., pulse signals and clock signals) generated by a timing generator. Note that the control section 113 and the processing section 114 may be integrally configured.

The pixel drive section 111, the signal processing section 112, the control section 113, and the processing section 114, for example, may be provided on a single semiconductor substrate or may be separately provided on a plurality of semiconductor substrates. The imaging device 1 may have a structure (stacked structure) including a plurality of substrates stacked.

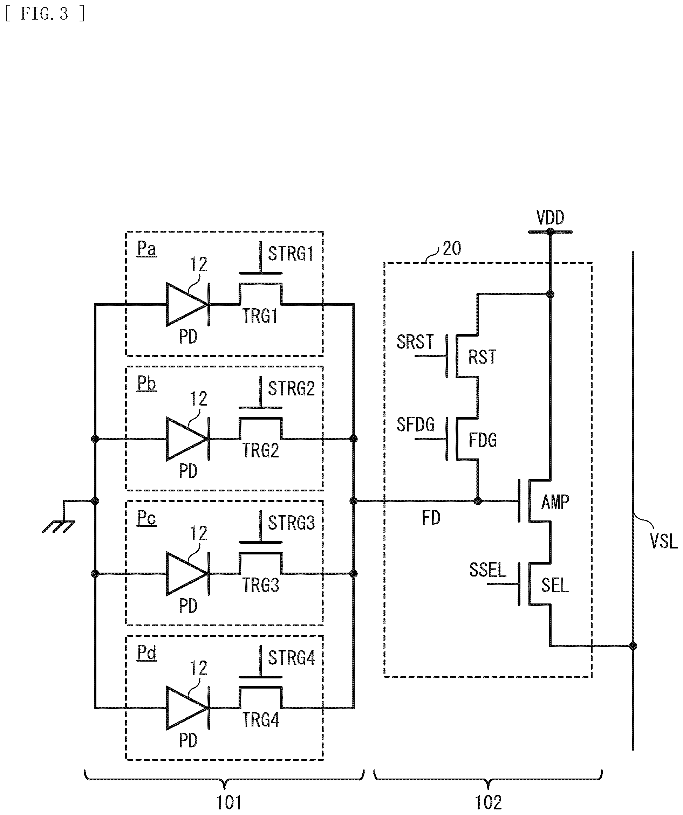

FIG. 3 is a diagram for explaining an example of the circuit configuration of a pixel of the imaging device according to the first embodiment. The pixels P of the imaging device 1 each include a photoelectric conversion section 12 (photoelectric conversion element), a transfer transistor TRG, a floating diffusion FD, and a readout circuit 20. The photoelectric conversion section 12 is configured to receive light and generate signals. The photoelectric conversion section 12 is a light receiver (light-receiving element) and is configured to generate an electric charge by photoelectric conversion.

The readout circuit 20 is configured to output a signal based on the photoelectrically converted charge. In the imaging device 1, the readout circuit 20 is provided for a plurality of pixels P. The imaging device 1 has a configuration in which a plurality of pixels P share one readout circuit 20.

In the example illustrated in FIG. 3, a readout circuit 20 is disposed for every group of four pixels P (referred to as pixels Pa to Pd). The pixels Pa, Pb, Pc, and Pd share one readout circuit 20. For example, a 2-by-2 pixels including adjacent pixels Pa to Pd shares one readout circuit 20.

The imaging device 1 may read out the pixel signals of each of the 2-by-2 pixels by operating the readout circuit 20 in a time-division manner. The imaging device 1 also makes it possible to read out a pixel signal in which the signals of the respective 2 by 2 pixels are added together. Note that the imaging device 1 may have a configuration in which five or more pixels P, for example, eight pixels P, share one readout circuit 20.

In the example illustrated in FIG. 3, the photoelectric conversion section 12 is a photodiode (PD) and converts entering light into an electric charge. The photoelectric conversion section 12 (in FIG. 3, the photodiode PD of pixel Pa to the photodiode PD of pixel Pd) performs photoelectric conversion to generate an electric charge according to the amount of light received.

The transfer transistors TRG (in FIG. 3, the transfer transistor TRG1 for the pixel Pa to the transfer transistor TRG4 for the pixel Pd) are configured to transfer the electric charge obtained by photoelectrical conversion in the photoelectric conversion section 12, to the floating diffusion FD. The transfer transistor TRG is controlled by the signal STRG and electrically couples or decouples the photoelectric conversion section 12 and the floating diffusion FD. The transfer transistor TRG may transfer the electric charge obtained by photoelectrical conversion in the photoelectric conversion section 12 and then accumulated, to the floating diffusion FD.

In the example illustrated in FIG. 3, the transfer transistors TRG of the respective pixels Pa to Pd are on-off controlled by different signals. The transfer transistor TRG1 of the pixel Pa is controlled by a signal STRG1, and the transfer transistor TRG2 of the pixel Pb is controlled by a signal STRG2. The transfer transistor TRG3 of the pixel Pc is controlled by a signal STRG3, and the transfer transistor TRG4 of the pixel Pd is controlled by a signal STRG4.

The floating diffusion FD is an accumulator and is configured to accumulate the transferred charge. The floating diffusion FD may accumulate the electric charge obtained by photoelectrical conversion in the photoelectric conversion section 12. The floating diffusion FD may also be referred to as a retainer configured to retain the transferred charge. The floating diffusion FD accumulates the transferred charge and converts it to a voltage corresponding to the capacitance of the floating diffusion FD.

As illustrated in FIG. 3, the readout circuit 20 includes, for example, an amplification transistor AMP, a selection transistor SEL, a transistor FDG, and a reset transistor RST. The amplification transistor AMP is configured to generate and output a signal based on the electric charge accumulated in the floating diffusion FD. As illustrated in FIG. 3, the gate of the amplification transistor AMP is electrically coupled to the floating diffusion FD and receives as an input the voltage that has been converted by the floating diffusion FD.

The drain of the amplification transistor AMP is coupled to a power supply line to which a power supply voltage VDD is supplied, and the source of the amplification transistor AMP is coupled to the signal line VSL via the selection transistor SEL. The amplification transistor AMP may generate a signal based on the electric charge accumulated in the floating diffusion FD, that is, a signal based on the voltage of the floating diffusion FD, and output it to the signal line VSL. The amplification transistor AMP is configured to generate a signal based on the electric charge that has been converted in the photoelectric conversion section 12.

The selection transistor SEL is configured to control the output of the signal of the pixel. The selection transistor SEL is controlled by the signal SSEL and is configured to output the signal from the amplification transistor AMP to the signal line VSL. The selection transistor SEL may control the timing of outputting the signal of the pixel. The selection transistor SEL is configured to output a signal based on the electric charge that has been converted in the photoelectric conversion section 12. The selection transistor SEL may be provided between the power supply line to which the power supply voltage VDD is given, and the amplification transistor AMP. The selection transistor SEL may be omitted as appropriate.

The transistor FDG is configured to electrically couple the floating diffusion FD and the reset transistor RST, for example. For example, the transistor FDG is controlled by the signal SFDG and electrically couples or decouples the floating diffusion FD and the reset transistor RST.

When the transistor FDG is turned on, the capacitance added to the floating diffusion FD of the pixel P is increased and it is possible to change the conversion efficiency (gain) obtained when charge is converted to voltage. The transistor FDG is a switching transistor that switches the capacitor coupled to the gate of the amplification transistor AMP and changes the conversion efficiency.

The reset transistor RST is configured to reset the voltage of the floating diffusion FD. In the example illustrated in FIG. 3, the reset transistor RST is electrically coupled to the power line to which the power supply voltage VDD is supplied and is configured to reset the electric charge of the pixel P.

The reset transistor RST is controlled by the signal SRST and may reset the electric charge accumulated in the floating diffusion FD and reset the voltage of the floating diffusion FD. Note that the reset transistor RST may discharge the electric charge accumulated in the photoelectric conversion section 12 via the transistor FDG and the transfer transistor TRG.

The transfer transistor TRG, the amplification transistor AMP, the selection transistor SEL, the transistor FDG (switching transistor), and the reset transistor RST described above are MOS transistors (MOSFETs) each including gate, source, and drain terminals.

In the example illustrated in FIG. 3, the transfer transistor TRG, the amplification transistor AMP, the selection transistor SEL, the transistor FDG, and the reset transistor RST are NMOS transistors. The transistors of the pixel P may be PMOS transistors. The transistors of the pixel P (e.g., the transfer transistor TRG, the amplification transistor AMP, the selection transistor SEL, the transistor FDG, and the reset transistor RST) may be 3D transistors, for example, Fin type transistors (Fin FETs).

The pixel drive section 111 (see FIG. 1) supplies control signals to the gates of the transfer transistor TRG, the selection transistor SEL, the transistor FDG, and the reset transistor RST, for example, of each pixel P via the control line Lread described above, thereby turning the transistors on (conducting state) or off (non-conducting state).

The plurality of control lines Lread of the imaging device 1 include wiring that transmits the signal STRG to control the transfer transistor TRG, wiring that transmits the signal SSEL to control the selection transistor SEL, wiring that transmits the signal SFDG to control the transistor FDG, and wiring that transmits the signal SRST to control the reset transistor RST, for example.

The transfer transistor TRG, the selection transistor SEL, the transistor FDG, and the reset transistor RST, for example, are on-off controlled by the pixel drive section 111. The pixel drive section 111 controls the readout circuit 20 of each pixel P to output a pixel signal from each pixel P to the signal line VSL. The pixel drive section 111 may control the readout of the pixel signal of each pixel P to the signal line VSL.

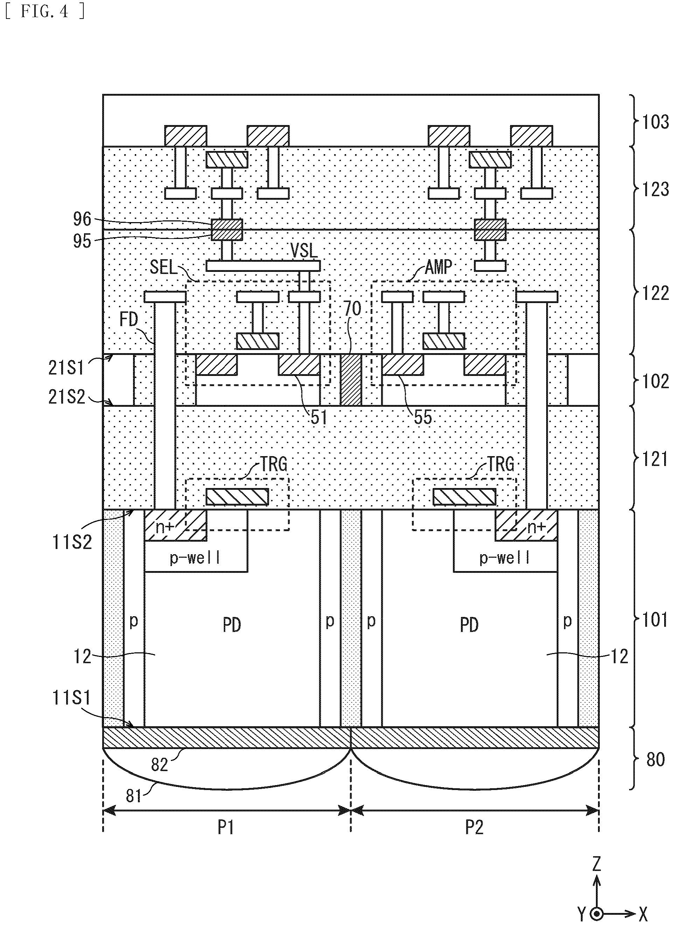

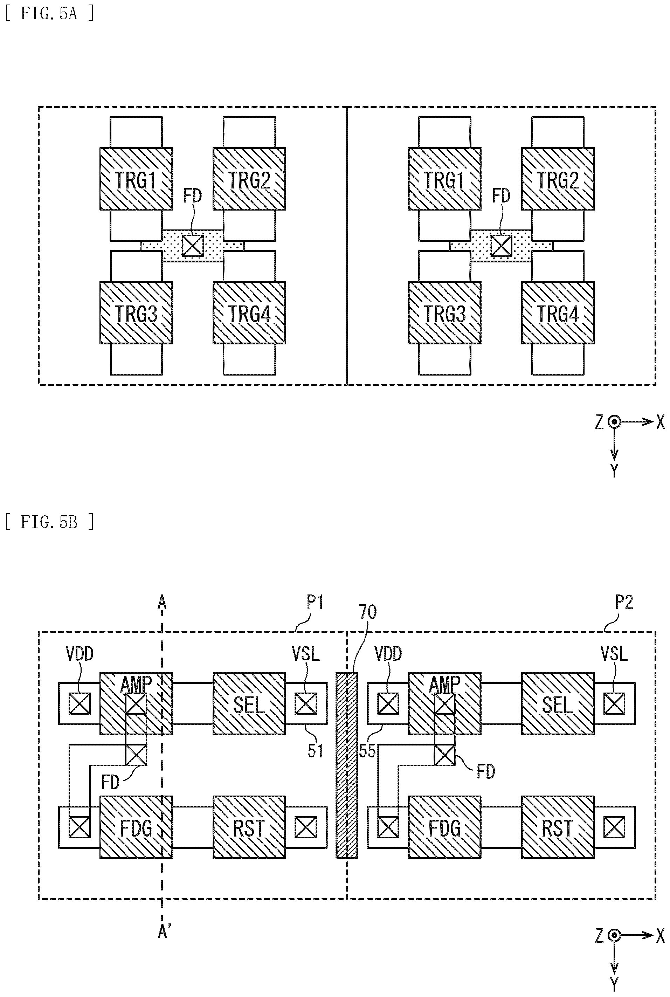

FIG. 4 is a diagram illustrating an example of the cross-sectional configuration of the imaging device according to the first embodiment. FIGs. 5A and 5B are diagrams illustrating an example of the planar configuration of the imaging device according to the first embodiment. As illustrated in FIG. 4, for example, the imaging device 1 includes a light-guiding section 80, a semiconductor layer 101, a wiring layer 121, a semiconductor layer 102, a wiring layer 122, a wiring layer 123, and a semiconductor layer 103.

FIG. 5A illustrates an example of the planar configuration of the semiconductor layer 101 and the wiring layer 121 of the imaging device 1. FIG. 5B illustrates an example of the planar configuration of the semiconductor layer 102 and the wiring layer 122 of the imaging device 1. In the following, out of two adjacent pixels, one pixel (e.g., the left pixel) and the other pixel (e.g., the right pixel) may be referred to as pixel P1 and pixel P2, respectively. Note that when a plurality of pixels (e.g., pixels Pa to Pd) share the readout circuit 20, the pixel P1 (or pixel P2) corresponds to a plurality of pixels and may also be referred to as a pixel unit (or pixel block) containing a plurality of pixels.

As illustrated in FIG. 4, for example, the imaging device 1 has a configuration in which the light-guiding section 80, the semiconductor layer 101, the wiring layer 121, the semiconductor layer 102, the wiring layer 122, the wiring layer 123, and the semiconductor layer 103 are stacked in the Z-axis direction. From the side where light enters, the light-guiding section 80, the semiconductor layer 101, the wiring layer 121, the semiconductor layer 102, the wiring layer 122, the wiring layer 123, and the semiconductor layer 103 are provided.

The semiconductor layer 101, the semiconductor layer 102, and the semiconductor layer 103 each are a semiconductor substrate (e.g., silicon substrate or silicon on insulator (SOI) substrate). For example, the semiconductor layer 102 may be a silicon layer on a buried oxide (BOX) layer in an SOI substrate.

The semiconductor layer 101 and the wiring layer 121 may also be referred to as a first substrate. The semiconductor layer 102 and the wiring layer 122 may also be referred to as a second substrate. The semiconductor layer 103 and the wiring layer 123 may also be referred to as a third substrate.

As illustrated in FIG. 4, the semiconductor layer 101 includes a first surface 11S1 and a second surface 11S2 opposed to each other. The second surface 11S2 is the surface on a side opposite to the first surface 11S1. The first surface 11S1 of the semiconductor layer 101 is a light-receiving surface (light-entrance surface). The second surface 11S2 of the semiconductor layer 101 is an element formation surface on which elements such as transistors are formed.

A gate electrode and a gate insulating film (e.g., a gate oxide film), for example, may be provided on the second surface 11S2 of the semiconductor layer 101. FIG. 4 illustrates the transfer transistors TRG of the pixels P1 and P2. The transfer transistors TRG are formed on the second surface 11S2 side of the semiconductor layer 101.

In the example illustrated in FIG. 4, the light-guiding section 80 is provided on the first surface 11S1 side of the semiconductor layer 101. The wiring layer 121 is provided on the second surface 11S2 side of the semiconductor layer 101. The light-guiding section 80 is provided on the side where light from the optical system enters, and the wiring layer 121 is provided on the side opposite to the side where the light enters.

In the semiconductor layer 101, a plurality of photoelectric conversion sections 12 (photoelectric conversion elements) are provided along the first surface 11S1 and the second surface 11S2 of the semiconductor layer 101. For example, the plurality of photoelectric conversion sections 12 are embedded in the semiconductor layer 101.

The wiring layer 121 has, for example, a conductor film and an insulating film, and includes a plurality of pieces of wiring and vias. The wiring layer 121 has a configuration in which a plurality of pieces of wiring are stacked with an insulating film therebetween. The insulating film of the wiring layer 121 may also be referred to as an interlayer insulating film (interlayer insulating layer).

The wiring of the wiring layer 121 includes, for example, a metal material, such as aluminum (Al), copper (Cu), or tungsten (W), for example. The wiring of the wiring layer 121 may include polysilicon (Poly-Si) or other conductive materials. The interlayer insulating film includes, for example, silicon oxide (SiO), silicon nitride (SiN), or silicon oxynitride (SiON).

The light-guiding section 80 is stacked on the semiconductor layer 101 in the thickness direction orthogonal to the first surface 11S1 of the semiconductor layer 101. The light-guiding section 80 includes a lens 81 and a filter 82 and guides the entering light toward the semiconductor layer 101. The photoelectric conversion section 12 photoelectrically converts the light entering through the lens 81 and the filter 82.

The lens 81 is an optical component which is also referred to as an on-chip lens. The lens 81 (lens section) is provided, for example, on the first surface 11S1 side of the semiconductor layer 101 for each pixel P or every group of a plurality of pixels P. Light from a subject enters the lens 81 through an optical system such as an imaging lens.

The pixel P may also include a filter 82. The filter 82 is configured to selectively transmit, out of entering light, light in a specific wavelength range. The filter 82 is, for example, an RGB color filter, a complementary color filter, or a filter transmitting infrared light, and is provided between the lens 81 and the semiconductor layer 101. The filter 82 is provided, for example, on the first surface 11S1 side of the semiconductor layer 101 for each pixel P or every group of a plurality of pixels P.

As illustrated in FIG. 4, the semiconductor layer 102 includes the first surface 21S1 and the second surface 21S2 opposed to each other. The second surface 21S2 is the surface on a side opposite to the first surface 21S1. A wiring layer 122 is provided on the first surface 21S1 side of the semiconductor layer 102, and a wiring layer 121 is provided on the second surface 21S2 side of the semiconductor layer 102.

The first surface 21S1 of the semiconductor layer 102 is the element formation surface on which elements such as transistors are formed. On the first surface 21S1 of the semiconductor layer 102, a gate electrode and a gate insulating film, for example, are provided. FIG. 4 illustrates the selection transistor SEL of the pixel P1 and the amplification transistor AMP of the pixel P2. On the first surface 21S1 of the semiconductor layer 102, the transistors (e.g., the amplification transistor AMP, the selection transistor SEL, the transistor FDG, and the reset transistor RST) of the readout circuit 20 of the pixel P (the pixels P1 and P2 in FIG. 4) described above may be provided.

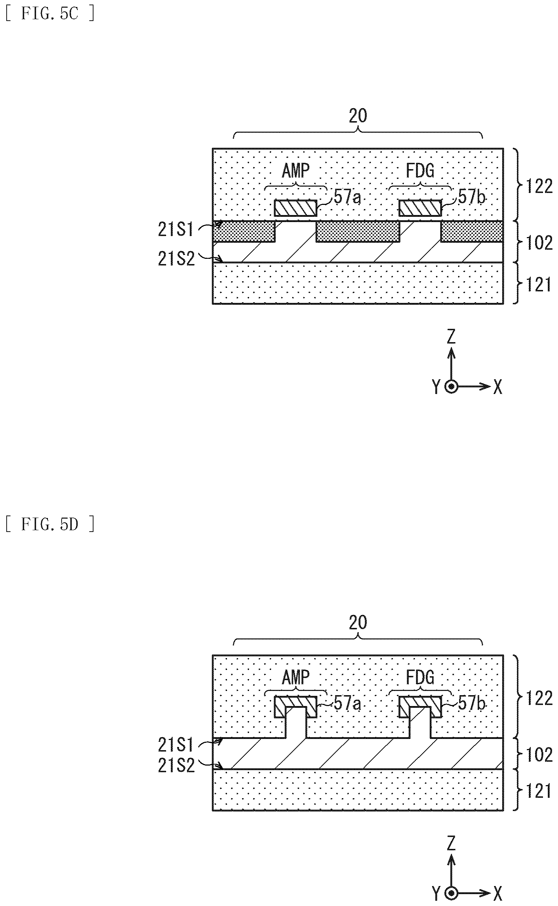

FIG. 5C is a diagram for explaining an example of the cross-sectional configuration of a pixel of the imaging device according to the first embodiment. FIG. 5C illustrates an example of the configuration of a pixel along the A-A' line illustrated in FIG. 5B. The transistors of the pixel P (e.g., the transfer transistor TRG, the amplification transistor AMP, the selection transistor SEL, the transistor FDG, and the reset transistor RST) have a planer structure as illustrated in the example in FIG. 5C, for example. The transistors (e.g., the amplification transistor AMP and the transistor FDG) of the pixel P may be configured as a planar transistor, for example.

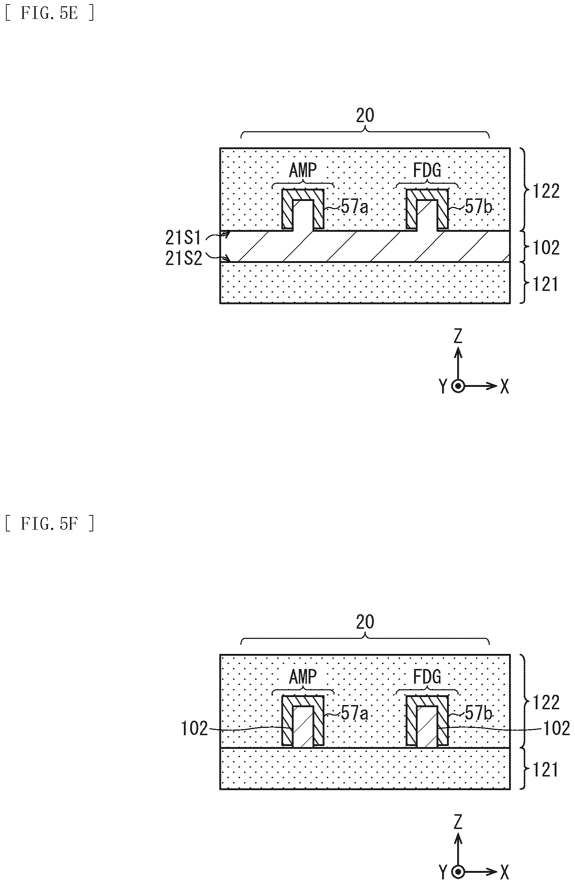

FIGs. 5D to 5G are diagrams for explaining another example of the cross-sectional configuration of a pixel of the imaging device according to the first embodiment. The transistors of the pixel P may be configured as Fin-type transistors, as in the examples illustrated in FIG. 5D, 5E or 5F. For example, the gate electrodes 57 of the transistors of the pixel P (in FIG. 5D, for example, the gate electrode 57a of the amplification transistor AMP and the gate electrode 57b of the transistor FDG) are provided on the first surface 21S1 side of the semiconductor layer 102, sandwiching a portion of the semiconductor layer 102.

The gate electrodes 57 of the transistors in the pixel P may be provided sandwiching a portion of the semiconductor layer 102 that serves as the channel region of the transistor, with a gate insulating film (not illustrated in the drawings) therebetween. For example, as in the example illustrated in FIG. 5D, the gate electrode 57a of the amplification transistor AMP and the gate electrode 57b of the transistor FDG may each be provided sandwiching an edge portion of the semiconductor layer 102.

As in the example illustrated in FIG. 5E, the gate electrodes 57 of the transistors of the pixel P, such as the gate electrodes 57a and 57b, may be provided adjacent to the first surface 21S1 of the semiconductor layer 102. Further, for example, as in the example illustrated in FIG. 5F, each of the gate electrodes 57a and 57b may be provided reaching the second surface 21S2 of the semiconductor layer 102, that is, the wiring layer 121 side.

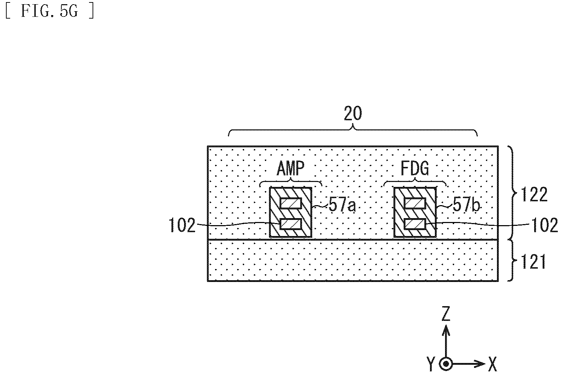

As illustrated in FIG. 5G, the transistors of the pixel P (e.g., the transfer transistor TRG, the amplification transistor AMP, the selection transistor SEL, the transistor FDG, and the reset transistor RST) may have a structure in which a gate is provided around a channel region, that is, a gate all around (GAA) structure.

The wiring layers 122 and 123 illustrated in FIG. 4, for example, each have, for example, a conductor film and an insulating film, and include a plurality of pieces of wiring and vias, for example. The wiring layers 122 and 123 include, for example, two or more layers of wiring. The wiring layers 122 and 123 each have a configuration in which a plurality of pieces of wiring are stacked with an insulating film (interlayer insulating film) therebetween.

The wiring of each of the wiring layers 122 and 123 contains a metal material such as aluminum (Al), copper (Cu), or tungsten (W), for example. The wiring of the wiring layers 122 and 123 may contain a conductive material such as polysilicon (Poly-Si). The interlayer insulating film contains, for example, silicon oxide (SiO), silicon nitride (SiN), or silicon oxynitride (SiON).

A plurality of electrodes 95 are provided in the wiring layer 122, and a plurality of electrodes 96 are provided in the wiring layer 123. The electrodes 95 and 96 are electrodes each containing, for example, copper (Cu). The electrodes 95 and 96 may also be referred to as bonding electrodes used for bonding between metal electrodes. As an example, the semiconductor layers 102 and 103 are bonded together by bonding between metal electrodes (electrodes 95 and 96) of Cu, that is, Cu-Cu bonding.

The electrodes 95 and 96 electrically couple the circuit of the semiconductor layer 102 and the circuit of the semiconductor layer 103. The semiconductor layer 103 and the wiring layer 123 may be provided with, for example, the pixel drive section 111, the signal processing section 112, the control section 113, and the processing section 114 described above. Note that the electrodes 95 and 96 may contain a metal material other than copper, such as nickel (Ni), cobalt (Co), or gold (Au). Further, the semiconductor layers 102 and 103 may be stacked using bumps.

The imaging device 1 includes an electric conductor 70 provided between a transistor of a pixel and the transistors of the surrounding pixels. As in the examples illustrated in FIGs. 4 and 5B, the electric conductor 70 is provided between a transistor of the pixel P1, which is one of two pixels P adjacent to each other in the left-right (or up-down) direction, and a transistor of the pixel P2, which is the other pixel. The electric conductor 70 is disposed, for example, between a transistor of the readout circuit 20 of the pixel P1 and a transistors of the readout circuit 20 of the pixel P2 in the semiconductor layer 102.

The electric conductor 70 may be disposed between the transistors of the pixel P1 (the selection transistor SEL or the amplification transistor AMP) coupled to the signal line VSL and the transistor of the pixel P2 (e.g., the amplification transistor AMP or the transistor FDG) coupled to the floating diffusion FD. The electric conductor 70 is a shielding region and is provided, in the semiconductor layer 102, for example, between the selection transistor SEL of the pixel P1 and the amplification transistor AMP of the pixel P2.

In the examples illustrated in FIGs. 4 and 5B, the electric conductor 70 is formed, in the semiconductor layer 102, between the semiconductor region 51 of the selection transistor SEL of the pixel P1 and the semiconductor region 55 of the amplification transistor AMP of the pixel P2. The semiconductor region 51 is, for example, a source region of the selection transistor SEL and is electrically coupled to the signal line VSL. The semiconductor region 55 is, for example, a drain region of the amplification transistor AMP and is electrically coupled to the power line to which the power supply voltage VDD is supplied.

The electric conductor 70 is electrically coupled to, for example, wiring or a terminal that allows a predetermined voltage to be supplied. The electric conductor 70 may also be considered a shielding region (shielding section). As an example, the electric conductor 70 is electrically coupled to wiring to be supplied with a fixed voltage. The electric conductor 70 may be supplied with a ground voltage or a power supply voltage via the wiring, for example, as a predetermined voltage (potential). The electric conductor 70 is electrically coupled to a ground line which is, for example, a reference potential line to which a ground voltage (GND voltage) is supplied.

The electric conductor 70 contains, for example, a semiconductor material doped (added) with an impurity or a metal material. As an example, the electric conductor 70 contains, for example, a semiconductor single-crystal (e.g., silicon) containing a high concentration of impurity or a semiconductor polycrystal (e.g., polysilicon) containing a high concentration of impurity. Note that the electric conductor 70 may contain tungsten (W), titanium nitride (TiN), titanium aluminum (TiAL), tantalum nitride (TaN), copper (Cu), aluminum (Al), or other conducting materials.

If the imaging device 1 does not include the electric conductor 70, there is a possibility that the parasitic capacitance between adjacent pixels increases, thereby increasing crosstalk. Noise caused by capacitive coupling between the floating diffusion FD and the signal line VSL may be mixed into the pixel signal, and the signal quality of the pixel signal may be degraded. As a result, there is a possibility that the image quality of the image generated using the pixel signals deteriorates. In particular, when the distance between pixels becomes smaller due to pixel miniaturization, parasitic capacitance tends to increase, resulting in crosstalk and degradation of pixel signal quality.

Consequently, in the imaging device 1 according to this embodiment, the electric conductor 70 is provided as described above. The electric conductor 70 is provided between the respective transistors of a plurality of adjacent pixels P. This allows unnecessary parasitic capacitance formed between pixels to be reduced, thereby suppressing crosstalk. It is possible to suppress noise entering the pixel signals.

### [Workings and Effects]

A photodetector according to this embodiment includes: a first photoelectric conversion element (the photoelectric conversion section 12) that photoelectrically converts light; a first readout circuit (e.g., the readout circuit 20 of the pixel P1) including a first transistor provided on a side of a first surface of a first semiconductor layer, the first readout circuit being configured to output a first signal based on electric charge obtained by conversion by the first photoelectric conversion element; a second photoelectric conversion element that photoelectrically converts light; a second readout circuit (e.g., the readout circuit 20 of the pixel P2) including a second transistor provided next to the first transistor on the side of the first surface of the first semiconductor layer, the second readout circuit being configured to output a second signal based on electric charge obtained by conversion by the second photoelectric conversion element; and an electric conductor (the electric conductor 70) provided between the first transistor and the second transistor.

In this photodetector (imaging device 1) according to this embodiment, the electric conductor 70 is provided between the selection transistor SEL of the pixel P1 and the amplification transistor AMP of the pixel P2. This allows unnecessary parasitic capacitance between the signal line VSL and the floating diffusion FD to be reduced, thereby suppressing crosstalk. It is possible to achieve a photodetector that enables suppression of degradation of signal quality.

Next, a modification of the present disclosure will be described. In the following, components that are similar to those in the embodiment described above will be denoted by the same reference numerals as in the embodiment described above, and explanations thereof will be omitted as appropriate.

### (1-1. Modification 1)

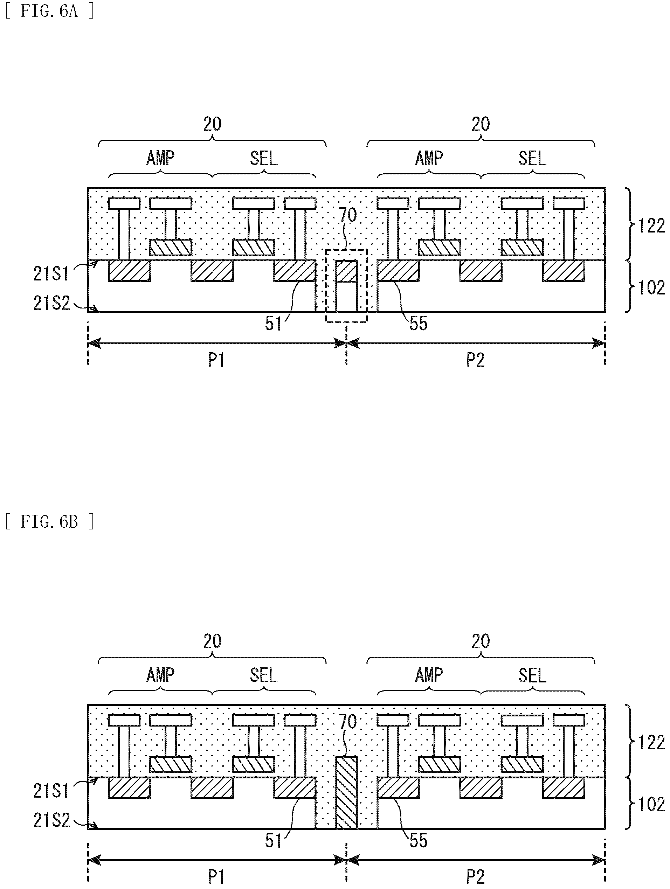

Although the embodiment described above has described examples of the configuration of the imaging device, the configuration of the imaging device is not limited to the examples described above. FIGs. 6A and 6B are diagrams for explaining examples of the configuration of the imaging device according to Modification 1 of the present disclosure. The electric conductor 70 may contain the same material as the source regions (or drain regions) of the transistors, or may contain the same material as the gate electrodes.

In the example illustrated in FIG. 6A, the electric conductor 70 may contain the same material as the source and drain regions of each transistor of the readout circuit 20 (e.g., the amplification transistor AMP or the selection transistor SEL), for example, silicon. The electric conductor 70 includes a semiconductor region doped with an impurity and is formed, for example, by ion implantation into the semiconductor layer 102 (silicon layer). This makes it possible to form the source and drain regions of the transistor and the electric conductor 70 simultaneously in the manufacturing steps, thereby reducing the number of steps. It is possible to suppress an increase in the manufacturing cost of the imaging device 1.

In the example illustrated in FIG. 6B, the electric conductor 70 may contain the same material as the gate electrodes of the transistors of the readout circuit 20 (e.g., the amplification transistor AMP and the selection transistor SEL), for example, polysilicon. This makes it possible to form the gate electrodes of the transistors and the electric conductor 70 simultaneously in the manufacturing steps, thereby reducing the number of steps. It is possible to suppress an increase in the manufacturing cost of the imaging device 1.

### (1-2. Modification 2)

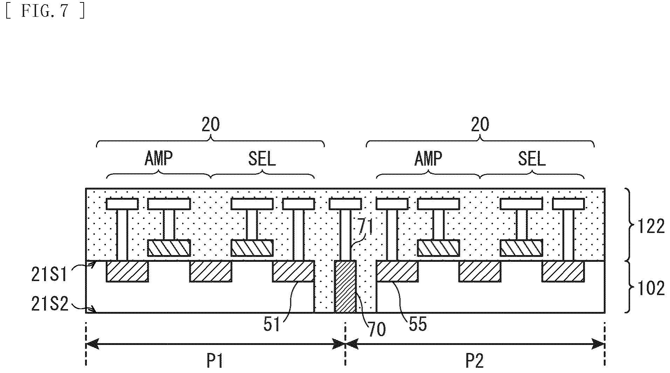

FIG. 7 is a diagram for explaining an example of the configuration of an imaging device according to Modification 2. As illustrated in the example illustrated in FIG. 7, the imaging device 1 may have an electrode 71 electrically coupled to the electric conductor 70. The electrode 71 is a contact, for example, provided on the first surface 21S1 side of the semiconductor layer 102 and electrically coupled to the electric conductor 70.

In the example illustrated in FIG. 7, the electrode 71 (contact) is disposed on the electric conductor 70 in the wiring layer 122. Note that the electric conductor 70 and the electrode 71 may be integrally configured. The electric conductor 70 and the electrode 71 may collectively be referred to as the electric conductor 70. In this modification, providing the electrode 71 makes it possible to improve the shielding performance.

### (1-3. Modification 3)

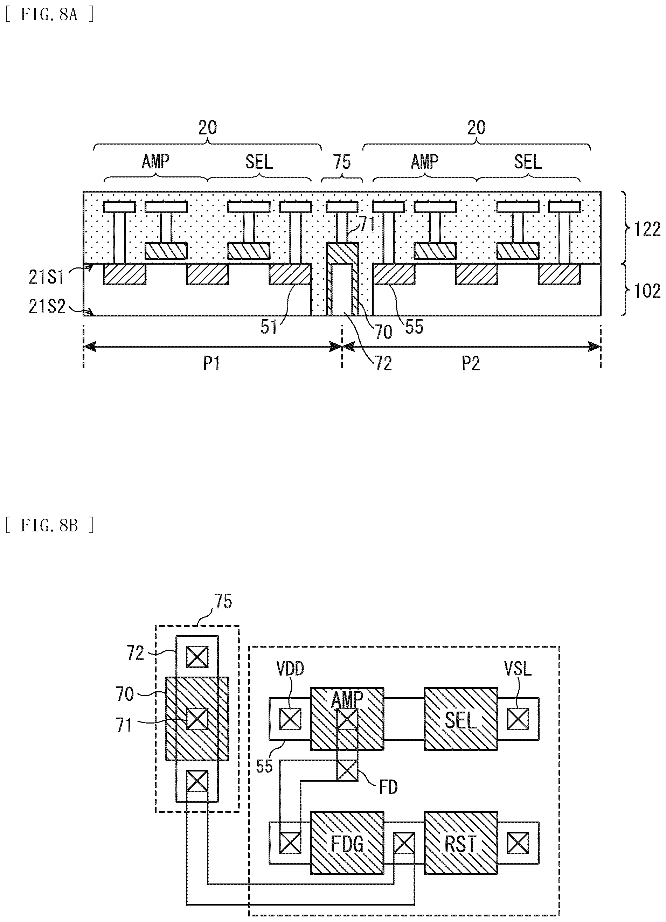

FIG. 8A is a diagram for explaining an example of the configuration of an imaging device according to Modification 3. As in the example illustrated in FIG. 8A, the semiconductor region 72 of the semiconductor layer 102, the electric conductor 70, and the electrode 71 may be provided. In this case, a capacitor 75 (CI capacitor) may be disposed that includes the semiconductor region 72, the electric conductor 70, and an insulating film (e.g., oxide film) between the semiconductor region 72 and the electric conductor 70. As illustrated in FIG. 8B, for example, the capacitor 75 is allowed to be electrically coupled to the transistor FDG and used as a capacitor for switching the conversion efficiency (gain).

### (1-4. Modification 4)

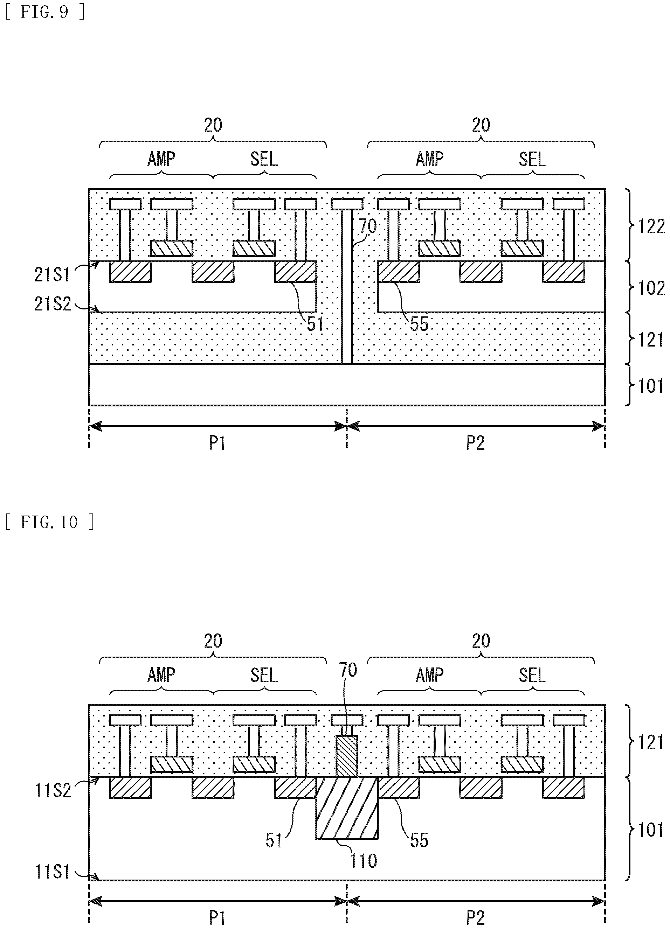

FIG. 9 is a diagram for explaining an example of the configuration of an imaging device according to Modification 4. As in the example illustrated in FIG. 9, an electrode that passes through the semiconductor layer 102 may be used as the electric conductor 70 which is a shielding region (shielding portion). For example, a through-electrode (through-contact) that electrically couples the circuit of the semiconductor layer 101 and the circuit of the semiconductor layer 102 may be used as the electric conductor 70.

### (1-5. Modification 5)

FIG. 10 is a diagram for explaining an example of the configuration of an imaging device according to Modification 5. The photoelectric conversion section 12, the transfer transistor TRG, and the readout circuit 20, for example, may be provided in a single semiconductor layer (e.g., the semiconductor layer 101). In the example illustrated in FIG. 10, the transistors of the readout circuit 20 are provided on the second surface 11S2 side of the semiconductor layer 101. Note that the transistors of the readout circuit 20 may be provided on the first surface 11S1 side of the semiconductor layer 101.

The imaging device 1 may include a separator 110, as in the example illustrated in FIG. 10. The separator 110 is formed, for example, in the semiconductor layer 101, between a plurality of adjacent photoelectric conversion sections 12 and separates the photoelectric conversion sections 12. The separator 110 includes a trench (groove portion) provided at the boundary of adjacent pixels P. The electric conductor 70 may be provided on the separator 110, as in the example illustrated in FIG. 10. Note that the separator 110 may be provided passing through the semiconductor layer 101.

### (1-6. Modification 6)

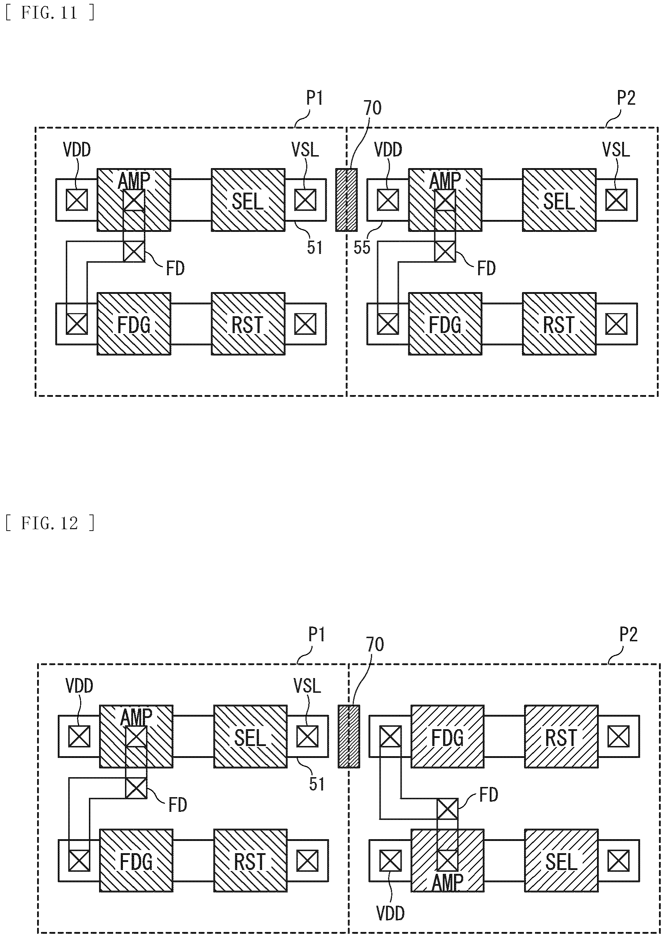

FIGs. 11 to 13 are diagrams for explaining an example of the configuration of an imaging device according to Modification 6. Although the embodiments and modifications described above have described examples of the configuration of the electric conductor 70, the positions and shapes of the electric conductor 70, for example, are not limited to the examples described above. For example, as illustrated in FIG. 11, the electric conductor 70 may be provided between the selection transistor SEL and the amplification transistor AMP. In the example illustrated in FIG. 11, the electric conductor 70 is disposed between the semiconductor region 51 of the selection transistor SEL and the semiconductor region 55 of the amplification transistor AMP.

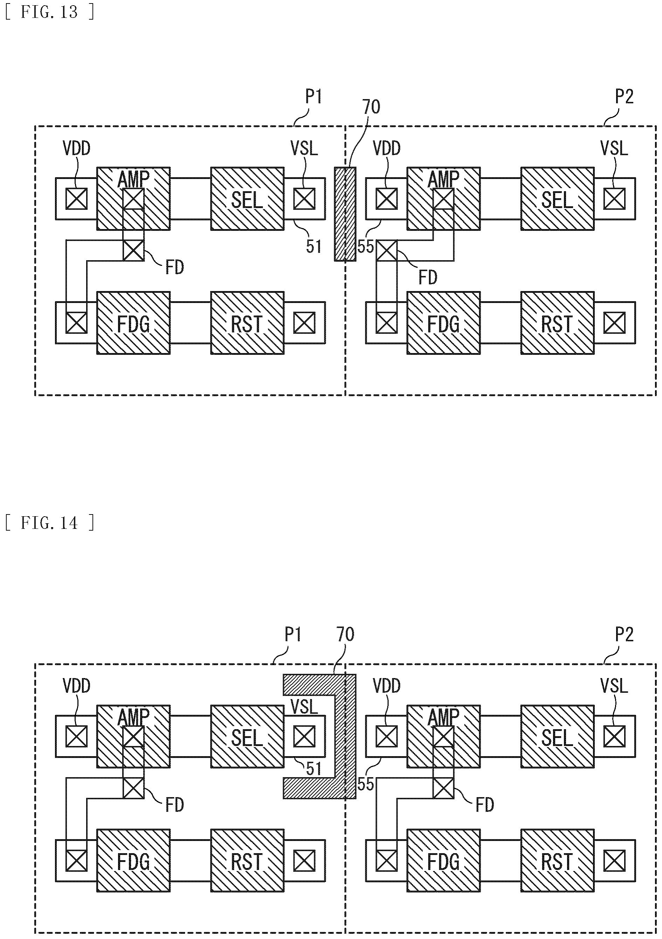

As illustrated in FIG. 12, the electric conductor 70 may be provided between the selection transistor SEL and the transistor FDG. Alternatively, as in the example illustrated in FIG. 13, the electric conductor 70 may be disposed between the selection transistor SEL and the wiring of the floating diffusion FD. For example, when the floating diffusion FD includes a through-electrode that passes through the semiconductor layer 102, the electric conductor 70 may be disposed around the through-electrode.

### (1-7. Modification 7)

FIG. 14 is a diagram for explaining an example of the configuration of an imaging device according to Modification 7. The electric conductor 70 may be provided to surround the signal line VSL coupled to the selection transistor SEL. As in the example illustrated in FIG. 14, the electric conductor 70 may be cornered U-shaped. The shape of the electric conductor 70 is not limited and may be rectangular, circular, or in any other shape.

### (1-8. Modification 8)

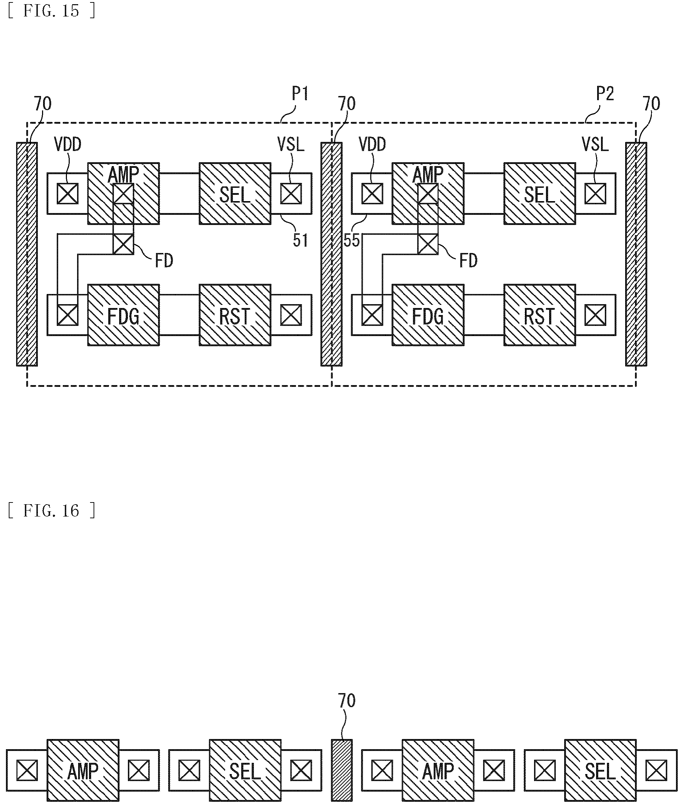

FIG. 15 is a diagram for explaining an example of the configuration of an imaging device according to Modification 8. As in the example illustrated in FIG. 15, the electric conductor 70 may be provided to maintain symmetry in the layout. The electric conductor 70 may also be disposed on both sides (at both ends) of the pixel P (or the readout circuit 20). This prevents the optical symmetry from deteriorating and the accuracy of photodetection from decreasing.

### (1-9. Modification 9)

FIG. 16 is a diagram for explaining an example of the configuration of an imaging device according to Modification 9. As in the example illustrated in FIG. 16, the amplification transistor AMP and the selection transistor SEL may be disposed separately. In the example illustrated in FIG. 16, the amplification transistor AMP and the selection transistor SEL may have separate source regions and drain regions. Note that the transistor FDG and the reset transistor RST may be disposed separately.

### <2. Second Embodiment>

Next, the second embodiment of the present disclosure will be described. In the following, components that are similar to those in the embodiment described above will be denoted by the same reference numerals as in the embodiment described above, and explanations thereof will be omitted as appropriate.

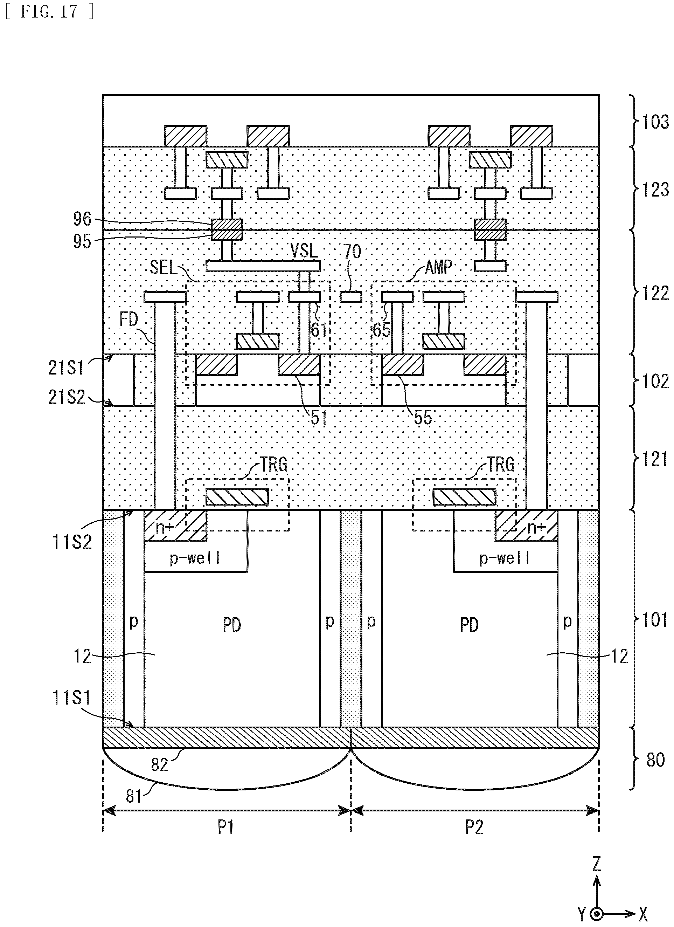

FIG. 17 is a diagram illustrating an example of the cross-sectional configuration of an imaging device according to a second embodiment of the present disclosure. In this embodiment, the electric conductor 70 may include wiring to be supplied with a predetermined potential. The electric conductor 70 is provided, for example, in the wiring layer 122, between a transistor of the readout circuit 20 of the pixel P1 and a transistor of the readout circuit 20 of the pixel P2. The electric conductor 70 may also be considered a shielding wiring.

The electric conductor 70 is disposed, for example, between the signal line VSL coupled to the readout circuit 20 of the pixel P1 and the wiring including at least a portion of the floating diffusion FD of the pixel P2. In the example illustrated in FIG. 17, the electric conductor 70 is provided between wiring 61 electrically coupled to the semiconductor region 51 of the selection transistor SEL of the pixel P1 and wiring 65 electrically coupled to the semiconductor region 55 of the amplification transistor AMP of the pixel P2. The wiring 61 is a portion of the signal line VSL.

The electric conductor 70 is electrically coupled to, for example, wiring or a terminal to be able to be supplied with a predetermined potential (voltage). A control line coupled to a transistor of the readout circuit 20 may be used as the electric conductor 70 to be supplied with the predetermined potential. Alternatively, wiring to be supplied with a boosted or stepped-down voltage (e.g., wiring coupled to the transfer transistor TRG or the reset transistor RST) may be used as the electric conductor 70.

In the imaging device 1, the electric conductor 70 is disposed by utilizing existing potential-fixed wiring, thereby reducing unnecessary parasitic capacitance. It is possible to suppress crosstalk. It is possible to reduce noise mixed into pixel signals and to prevent image quality degradation.

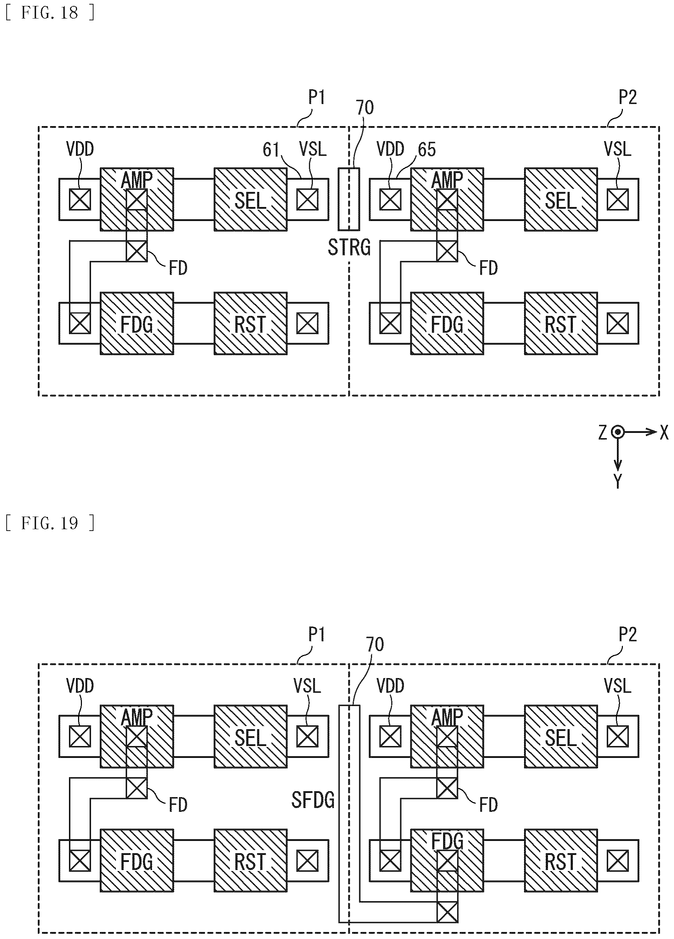

FIGs. 18 to 21 illustrate examples of configurations of the second type of imaging device. For example, as illustrated in FIG. 18, the wiring that transmits the signal STRG which controls the transfer transistor TRG may be disposed as the electric conductor 70. The electric conductor 70 serves as a portion of the wiring (control line) electrically coupled to the transfer transistor TRG. As illustrated in FIG. 19, the wiring that transmits the signal SFDG which controls the transistor FDG may be disposed as the electric conductor 70. The electric conductor 70 serves as a portion of the wiring electrically coupled to the transistor FDG.

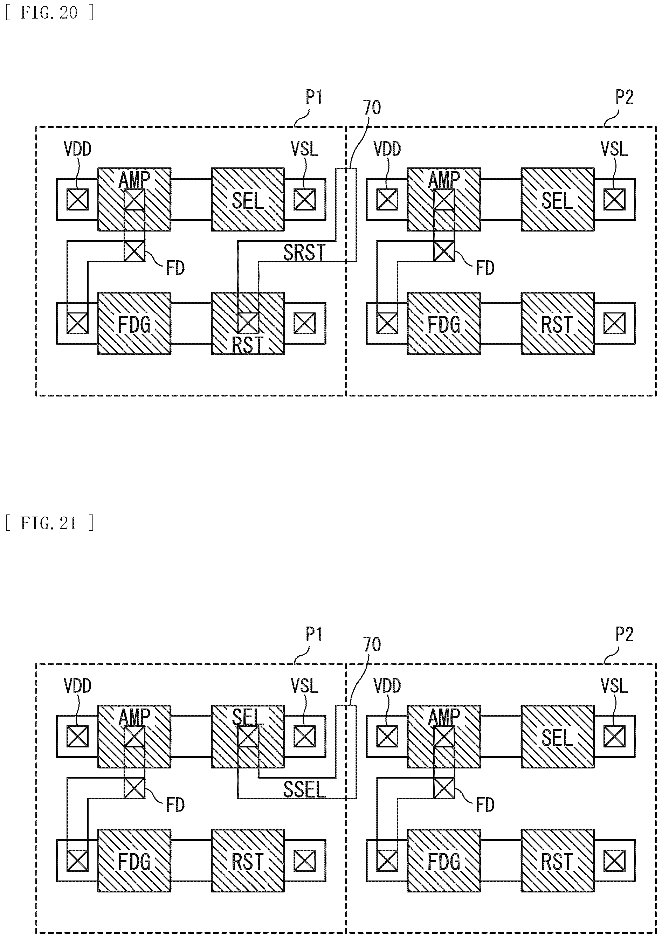

As illustrated in FIG. 20, the wiring that transmits the signal SRST which controls the reset transistor RST may be disposed as the electric conductor 70. The electric conductor 70 serves as a portion of the wiring electrically coupled to the reset transistor RST. As illustrated in FIG. 21, the wiring that transmits the signal SSEL which controls the selection transistor SEL may be disposed as the electric conductor 70. The electric conductor 70 serves as a portion of the wiring electrically coupled to the selection transistor SEL.

### [Workings and Effects]

A photodetector according to this embodiment includes: a first photoelectric conversion element (the photoelectric conversion section 12) that photoelectrically converts light; a first readout circuit (e.g., the readout circuit 20 of the pixel P1) including a first transistor provided on a side of a first surface of a first semiconductor layer, the first readout circuit being configured to output a first signal based on electric charge obtained by conversion by the first photoelectric conversion element; a second photoelectric conversion element that photoelectrically converts light; a second readout circuit (e.g., the readout circuit 20 of the pixel P2) including a second transistor provided next to the first transistor on the side of the first surface of the first semiconductor layer, the second readout circuit being configured to output a second signal based on electric charge obtained by conversion by the second photoelectric conversion element; and an electric conductor (the electric conductor 70) provided between the first transistor and the second transistor. The electric conductor is wiring supplied with a predetermined potential.

In this photodetector (imaging device 1), the electric conductor 70 is provided between the selection transistor SEL of the pixel P1 and the amplification transistor AMP of the pixel P2. The electric conductor 70 is wiring to be supplied with a predetermined potential. This allows unnecessary parasitic capacitance between the signal line VSL and the floating diffusion FD to be reduced, thereby suppressing crosstalk. It is possible to achieve a photodetector that enables suppression of degradation of signal quality.

Next, a modification of the present disclosure will be described. In the following, components that are similar to those in the embodiment described above will be denoted by the same reference numerals as in the embodiment described above, and explanations thereof will be omitted as appropriate.

### (2-1. Modification 10)

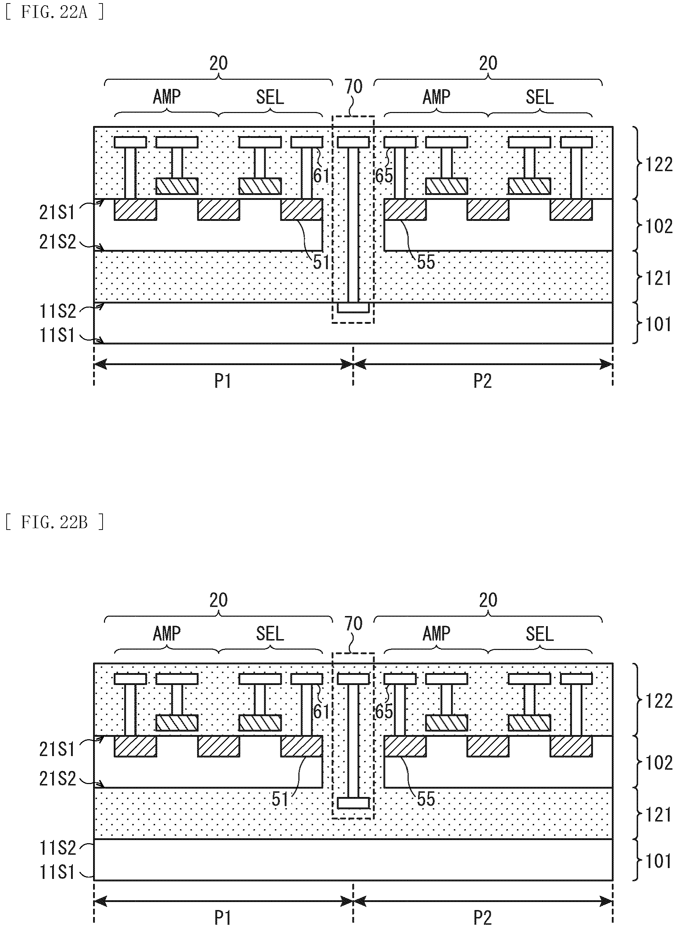

FIGs. 22A and 22B are diagrams for explaining examples of the configuration of the imaging device according to Modification 10. The electric conductor 70 may be provided, passing through the semiconductor layer 102. For example, as illustrated in FIG. 22A, the electric conductor 70 may be provided, reaching the second surface 11S2 of the semiconductor layer 101.

For example, as illustrated in FIG. 22B, the electric conductor 70 may be provided from the first surface 21S1 side of the semiconductor layer 102 to the inside of the wiring layer 121. This modification makes it possible to produce effects similar to those in the embodiment described above.

### <3. Third Embodiment>

Next, a third embodiment of the present disclosure will be described. In the following, components that are similar to those in the embodiment described above will be denoted by the same reference numerals as in the embodiment described above, and explanations thereof will be omitted as appropriate.

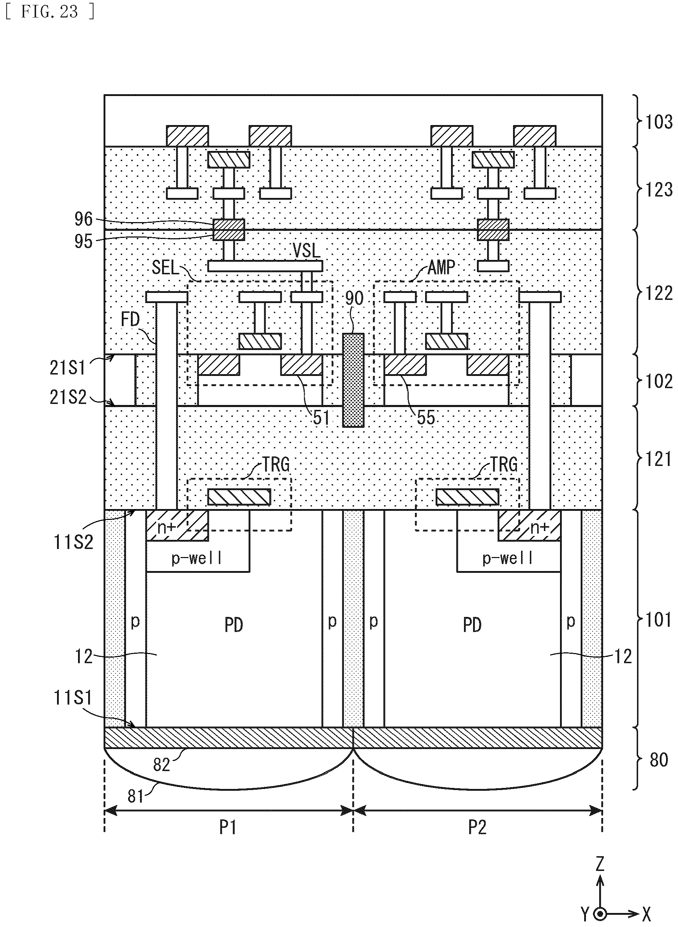

FIG. 23 is a diagram illustrating an example of the cross-sectional configuration of an imaging device according to the third embodiment of the present disclosure. The imaging device 1 according to this embodiment includes an insulator 90 provided between a transistor of a pixel and a transistor of the neighboring pixel. The insulator 90 has a dielectric constant that is lower than, for example, the dielectric constant of the insulating film around the transistors in the readout circuit 20.

As an example, the insulator 90 is provided on the first surface 21S1 side of the semiconductor layer 102 and contains a material having a dielectric constant lower than that of the insulating film of the wiring layer 122. The insulator 90 has a dielectric constant lower than that of the insulating film (interlayer insulating film) of the wiring layer 122. Further, for example, the insulator 90 may contain a material having a dielectric constant lower than that of the insulating film (interlayer insulating film) of the wiring layer 121, and may have a dielectric constant lower than that of the insulating film of the wiring layer 121.

As an example, the insulator 90 may contain, for example, SiOC or SiOCH which is a low-k material. The insulator 90 may include an insulating film having a dielectric constant lower than that of the silicon oxide film. The insulator 90 may also be considered a low-k section.

The insulator 90 may contain, for example, a material having a relative permittivity of greater than or equal to 1.5 and less than or equal to 3.8. The insulator 90 may contain, for example, SiOC, SiOCH, porous silica, SiOF, inorganic SOG, organic SOG, or polyaryl ether. Note that the insulator 90 may include a monolayer film containing one of the materials described above or a multilayer film containing two or more of these materials.

The insulator 90 is provided, for example, in the semiconductor layer 102, between a transistor of the readout circuit 20 of the pixel P1 and a transistor of the readout circuit 20 of the pixel P2. The insulator 90 is disposed, for example, between the signal line VSL coupled to the readout circuit 20 of the pixel P1 and the node of the floating diffusion FD of the pixel P2.

In the example illustrated in FIG. 23, the insulator 90 is provided between the semiconductor region 51 of the selection transistor SEL of the pixel P1 and the semiconductor region 55 of the amplification transistor AMP of the pixel P2. The insulator 90 is a low-k member as described above and is embedded. In this embodiment, providing the insulator 90 reduces unnecessary parasitic capacitance and suppresses crosstalk. It is possible to suppress the mixture of noise into pixel signals and suppress image quality degradation.

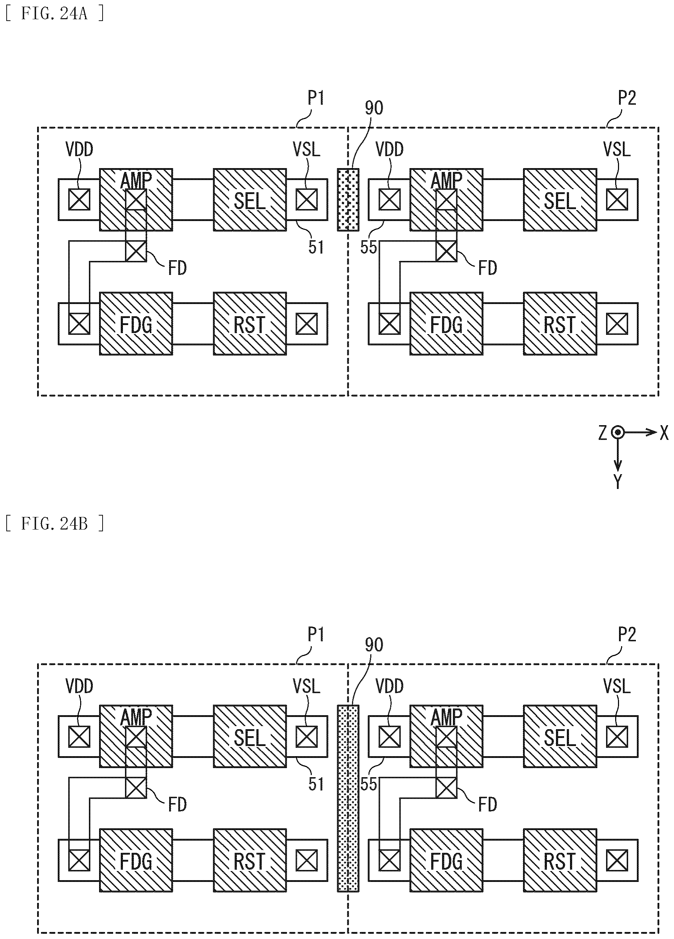

FIGs. 24A and 24B are diagrams for explaining examples of the configuration of the imaging device according to the third embodiment. For example, as illustrated in FIG. 24A or 24B, the insulator 90 may be provided between the selection transistor SEL and the amplification transistor AMP. Alternatively, the insulator 90 may also be disposed between the selection transistor SEL and the wiring of the floating diffusion FD. As in the example illustrated in FIG. 24B, the insulator 90 may be provided from between the selection transistor SEL and the amplification transistor AMP to between the selection transistor SEL and the transistor FDG.

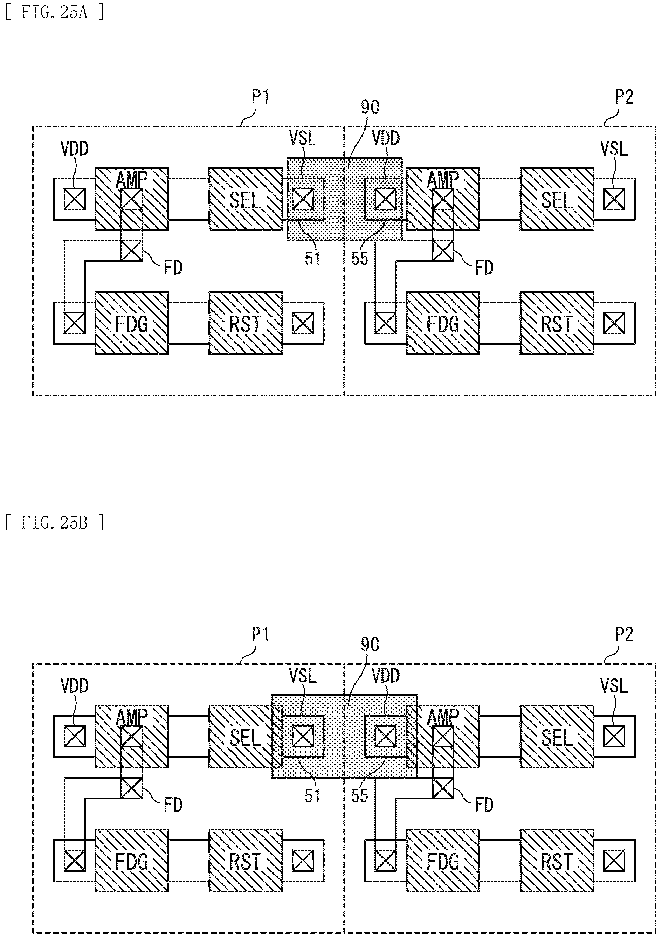

FIGs. 25A and 25B are diagrams for explaining other examples of the configuration of the imaging device according to the third embodiment. The insulator 90 may be provided, overlapping a portion of the semiconductor region 51 of the selection transistor SEL and a portion of the semiconductor region 55 of the amplification transistor AMP. As illustrated in FIG. 25A, the insulator 90 may be formed, covering a portion of the semiconductor region 51 of the selection transistor SEL and a portion of the semiconductor region 55 of the amplification transistor AMP.

The insulator 90 may be provided, overlapping a portion of the gate of the selection transistor SEL and a portion of the gate of the amplification transistor AMP. For example, as illustrated in FIG. 25B, the insulator 90 may be formed, also covering a portion of the gate of the selection transistor SEL and a portion of the gate of the amplification transistor AMP.

Note that the insulator 90 may have an insulating film and an air gap (void). An air gap (cavity) may be provided in the insulator 90. Further, the insulator 90 may be formed on the entire pixel P (or the readout circuit 20). Alternatively, for example, the insulator 90 may be provided on the entire first surface 21S1 of the semiconductor layer 102. Alternatively, the insulator 90 may be provided on the entire second surface 21S2 of the semiconductor layer 102.

### [Workings and Effects]

A photodetector according to this embodiment includes: a first photoelectric conversion element (the photoelectric conversion section 12) that photoelectrically converts light; a first readout circuit (e.g., the readout circuit 20 of the pixel P1) including a first transistor provided on a side of a first surface of a first semiconductor layer, the first readout circuit being configured to output a first signal based on electric charge obtained by conversion by the first photoelectric conversion element; a second photoelectric conversion element that photoelectrically converts light; a second readout circuit (e.g., the readout circuit 20 of the pixel P2) including a second transistor provided next to the first transistor on the side of the first surface of the first semiconductor layer, the second readout circuit being configured to output a second signal based on electric charge obtained by conversion by the second photoelectric conversion element; and an insulator (the insulator 90) provided, in the first semiconductor layer, between the first transistor and the second transistor.

In the photodetector (imaging device 1) according to this embodiment, the insulator 90 is provided between the selection transistor SEL of the pixel P1 and the amplification transistor AMP of the pixel P2. This allows unnecessary parasitic capacitance between the signal line VSL and the floating diffusion FD to be reduced, thereby suppressing crosstalk. It is possible to achieve a photodetector that enables suppression of degradation of signal quality.

### <4. Application Example>

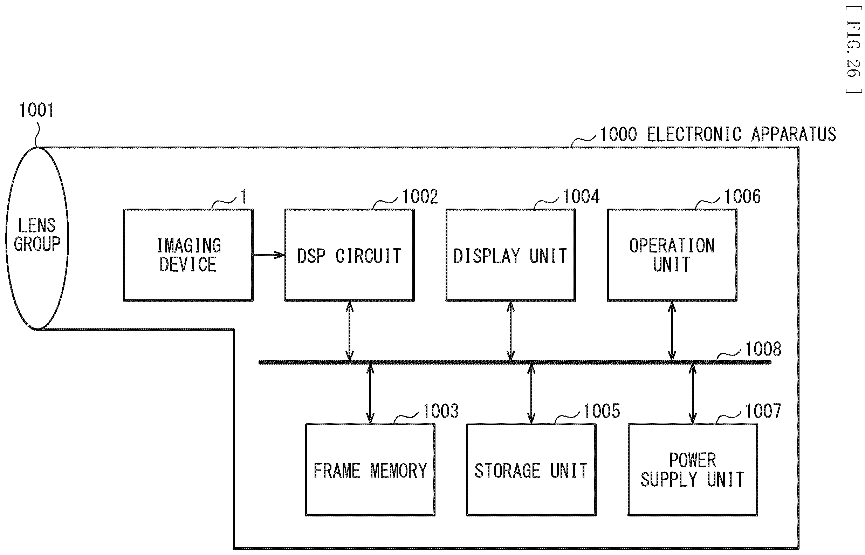

The above-described imaging device 1 or the like is applicable, for example, to any type of electronic apparatus with an imaging function including a camera system such as a digital still camera or a video camera, a mobile phone having an imaging function, and the like. FIG. 26 illustrates a schematic configuration of an electronic apparatus 1000.

The electronic apparatus 1000 includes, for example, a lens group 1001, the imaging device 1, a DSP (Digital Signal Processor) circuit 1002, a frame memory 1003, a display unit 1004, a recording unit 1005, an operation unit 1006, and a power supply unit 1007. They are coupled to each other via a bus line 1008.

The lens group 1001 takes in incident light (image light) from a subject, and forms an image on an imaging surface of the imaging device 1. The imaging device 1 converts the amount of incident light formed as an image on the imaging surface by the lens group 1001 into electric signals on a pixel-by-pixel basis, and supplies the DSP circuit 1002 with the electric signals as pixel signals.

The DSP circuit 1002 is a signal processing circuit that processes signals supplied from the imaging device 1. The DSP circuit 1002 outputs image data obtained by processing the signals from the imaging device 1. The frame memory 1003 temporarily holds the image data processed by the DSP circuit 1002 on a frame-by-frame basis.

The display unit 1004 includes, for example, a panel-type display device such as a liquid crystal panel or an organic EL (Electro Luminescence) panel, and records image data of a moving image or a still image captured by the imaging device 1 in a recording medium such as a semiconductor memory or a hard disk.

The operation unit 1006 outputs an operation signal for a variety of functions of the electronic apparatus 1000 in accordance with an operation by a user. The power supply unit 1007 appropriately supplies the DSP circuit 1002, the frame memory 1003, the display unit 1004, the recording unit 1005, and the operation unit 1006 with various kinds of power for operations of these supply targets.

### <5. Practical Application Examples>

### (Example of Practical Application to Mobile Body)

The technology (the present technology) according to the present disclosure is applicable to a variety of products. For example, the technology according to the present disclosure may be achieved as a device mounted on any type of mobile body such as an automobile, an electric vehicle, a hybrid electric vehicle, a motorcycle, a bicycle, a personal mobility, an aircraft, a drone, a vessel, or a robot.

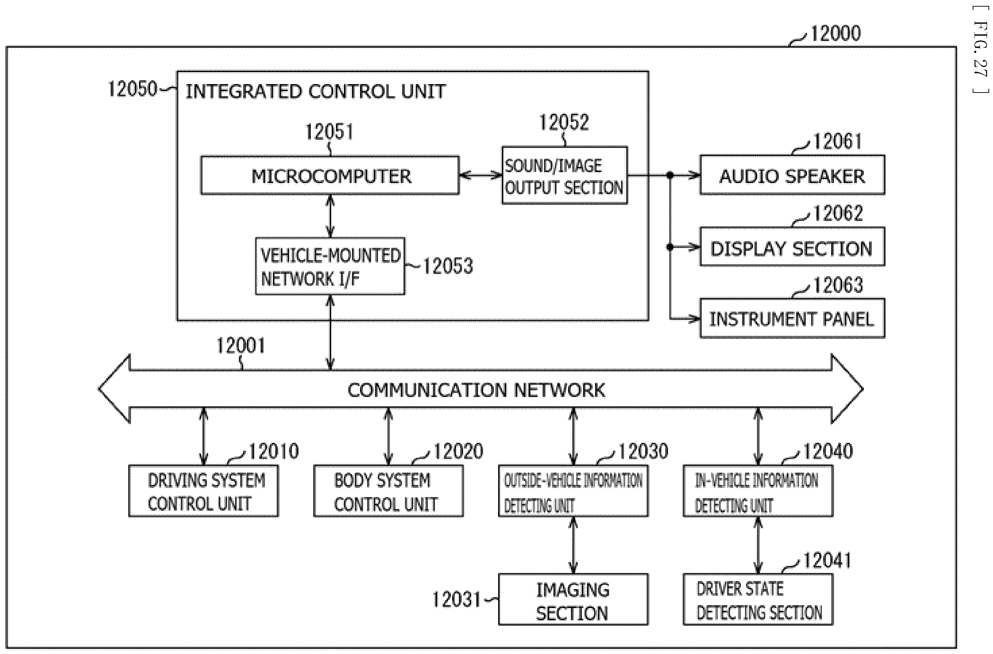

FIG. 27 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 27, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 27, an audio speaker 12061, a display section 12062, and an instrument panel 12063 are illustrated as the output device. The display section 12062 may, for example, include at least one of an on-board display and a head-up display.

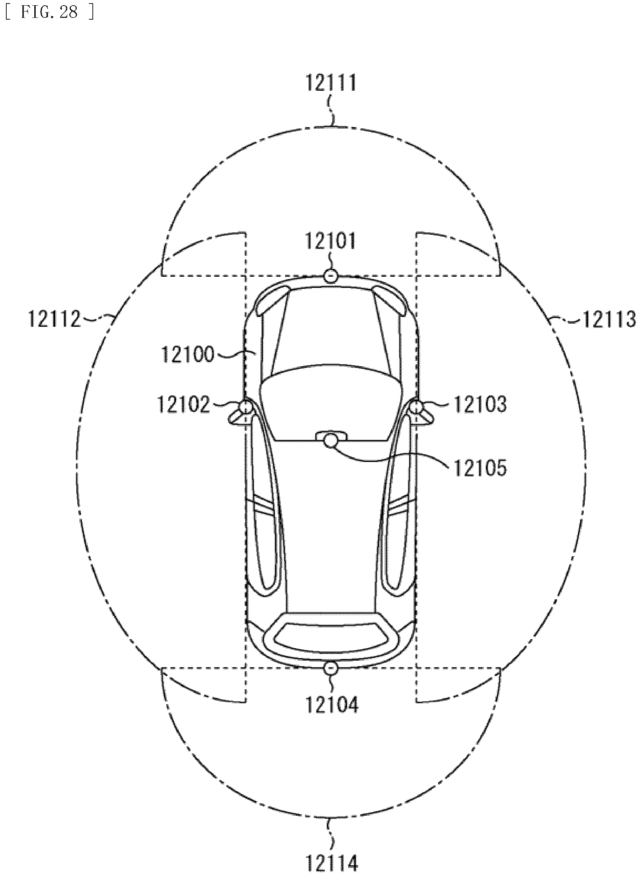

FIG. 28 is a diagram depicting an example of the installation position of the imaging section 12031.

In FIG. 28, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 28 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given hereinabove of the mobile body control system to which the technology according to an embodiment of the present disclosure is applicable. The technology according to an embodiment of the present disclosure is applicable to the imaging section 12031, for example, of the configurations described above. Specifically, for example, the imaging device 1 or the like can be applied to the imaging section 12031. Applying the technology according to an embodiment of the present disclosure to the imaging section 12031 enables obtainment of a photographed image having high definition. This makes it possible to perform highly accurate control utilizing the photographed image in the mobile body control system.

### (Example of Practical Application to Endoscopic Surgery System)

The technology according to an embodiment of the present disclosure (present technology) is applicable to various products. For example, the technology according to an embodiment of the present disclosure may be applied to an endoscopic surgery system.

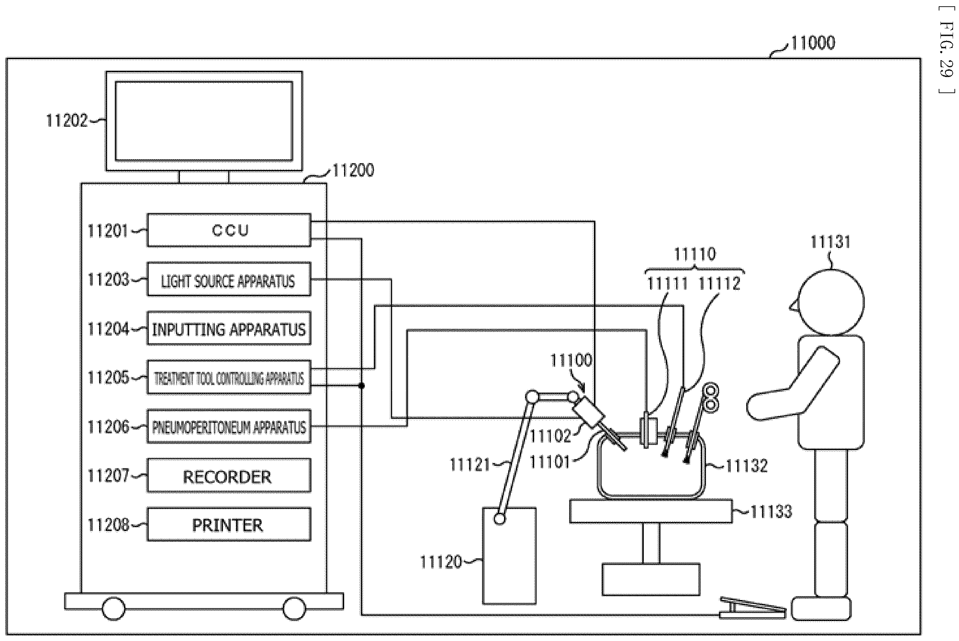

FIG. 29 is a view depicting an example of a schematic configuration of an endoscopic surgery system to which the technology according to an embodiment of the present disclosure (present technology) can be applied.

In FIG. 29, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (auto fluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

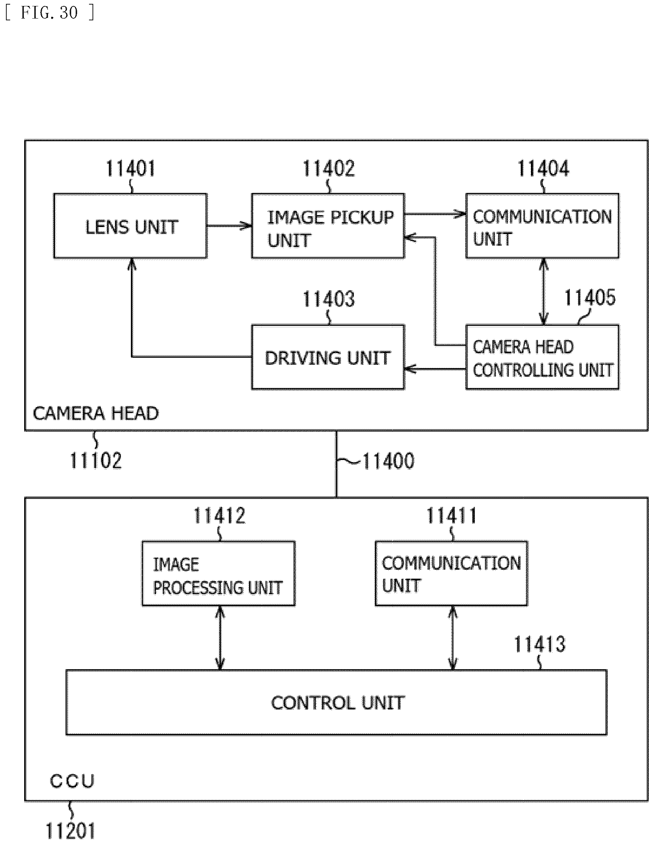

FIG. 30 is a block diagram depicting an example of a functional configuration of the camera head 11102 and the CCU 11201 depicted in FIG. 29.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given hereinabove of one example of the endoscopic surgery system, to which the technology according to an embodiment of the present disclosure is applicable. The technology according to an embodiment of the present disclosure is suitably applicable to, for example, the image pickup unit 11402 provided in the camera head 11102 of the endoscope 11100 of the configurations described above. Applying the technology according to an embodiment of the present disclosure to the image pickup unit 11402 makes it possible to provide the endoscope 11100 having high definition.

Although the description has been given hereinabove of the present disclosure with reference to the embodiment, the modification examples, the application example, and the practical application examples, the present technology is not limited to the foregoing embodiment and the like, and may be modified in a wide variety of ways. For example, although the foregoing modification examples have been described as modification examples of the foregoing embodiment, the configurations of the respective modification examples may be combined as appropriate. For example, the present disclosure is not limited to a back side illumination image sensor, but is also applicable to a front side illumination image sensor.

In the foregoing embodiment and the like, the imaging device has been exemplified for description. However, it is sufficient for the photodetector of the present disclosure to be, for example, a device that receives incident light and converts the light into electric charge. A signal to be outputted may be a signal of image information or a signal of information on a measured distance. The photodetector (imaging device) is applicable to an image sensor, a distance measurement sensor, or the like.

The photodetector according to the present disclosure is also applicable as a distance measurement sensor that enables distance measurement of a TOF (Time Of Flight) method. The photodetector (imaging device) is also applicable as a sensor that is able to detect an event, e.g., an event-driven sensor (referred to as EVS (Event Vision Sensor), EDS (Event Driven Sensor), DVS (Dynamic Vision Sensor), etc.).

A photodetector according to an embodiment of the present disclosure includes: a first photoelectric conversion element that photoelectrically converts light, a first readout circuit including a first transistor provided on a side of a first surface of a first semiconductor layer, the first readout circuit being configured to output a first signal based on electric charge obtained by conversion by the first photoelectric conversion element; a second photoelectric conversion element that photoelectrically converts light; a second readout circuit including a second transistor provided next to the first transistor on the side of the first surface of the first semiconductor layer, the second readout circuit being configured to output a second signal based on electric charge obtained by conversion by the second photoelectric conversion element; and an electric conductor provided between the first transistor and the second transistor. This makes it possible to achieve a photodetector that enables suppression of degradation of signal quality.

A photodetector according to an embodiment of the present disclosure includes: a first photoelectric conversion element that photoelectrically converts light; a first readout circuit including a first transistor provided on a side of a first surface of a first semiconductor layer, the first readout circuit being configured to output a first signal based on electric charge obtained by conversion by the first photoelectric conversion element; a second photoelectric conversion element that photoelectrically converts light; a second readout circuit including a second transistor provided next to the first transistor on the side of the first surface of the first semiconductor layer, the second readout circuit being configured to output a second signal based on electric charge obtained by conversion by the second photoelectric conversion element; and an insulator provided, in the first semiconductor layer, between the first transistor and the second transistor. This makes it possible to achieve a photodetector that enables suppression of degradation of signal quality.

It is to be noted that the effects described herein are merely exemplary and are not limited to the description, and may further include other effects. In addition, the present disclosure may also have the following configurations.
(1) A photodetector including:
   a first photoelectric conversion element that photoelectrically converts light;
   a first readout circuit including a first transistor provided on a side of a first surface of a first semiconductor layer, the first readout circuit being configured to output a first signal based on electric charge obtained by conversion by the first photoelectric conversion element;
   a second photoelectric conversion element that photoelectrically converts light;
   a second readout circuit including a second transistor provided next to the first transistor on the side of the first surface of the first semiconductor layer, the second readout circuit being configured to output a second signal based on electric charge obtained by conversion by the second photoelectric conversion element; and
   an electric conductor provided between the first transistor and the second transistor.
(2) The photodetector according to (1), in which the electric conductor is provided, in the first semiconductor layer, between the first transistor and the second transistor.
(3) The photodetector according to (1) or (2), further including an electrode provided on the side of the first surface of the first semiconductor layer, the electrode being electrically coupled to the electric conductor.
(4) The photodetector according to any one of (1) to (3), including a second semiconductor layer including the first photoelectric conversion element and the second photoelectric conversion element, in which
   the first semiconductor layer is stacked on the second semiconductor layer.
(5) The photodetector according to any one of (1) to (4), further including a first floating diffusion, in which
   the first transistor is configured to output the first signal based on electric charge accumulated in the first floating diffusion.
(6) The photodetector according to any one of (1) to (5), further including a signal line configured to transmit the first signal, in which
   the first transistor includes a first semiconductor region provided on the side of the first surface of the first semiconductor layer, the first semiconductor region being electrically coupled to the signal line, and
   the electric conductor is provided between the first semiconductor region and the second transistor.
(7) The photodetector according to any one of (1) to (6), further including a second floating diffusion, in which
   the second transistor is electrically coupled to the second floating diffusion.
(8) The photodetector according to any one of (1) to (7), in which the electric conductor is configured by a semiconductor material doped with an impurity, or by a metal material.
(9) The photodetector according to any one of (1) to (8), in which
   the first readout circuit includes an amplification transistor and the first transistor, the amplification transistor being configured to generate the first signal, the first transistor being configured to output the first signal,
   the second readout circuit includes the second transistor and a selection transistor, the second transistor being configured to generate the second signal, the selection transistor being configured to output the second signal,
   the amplification transistor, the first transistor, the second transistor, and the selection transistor are provided side by side in a first direction, and
   the electric conductor is provided between the first transistor and the second transistor in a plan view.
(10) The photodetector according to (1), in which the electric conductor includes wiring supplied with a predetermined potential.
(11) The photodetector according to (10), further including:
   first wiring that is electrically coupled to the first transistor; and
   second wiring that is electrically coupled to the second transistor, in which
   the first transistor is configured to output the first signal to the first wiring, and
   the electric conductor is provided between the first wiring and the second wiring.
(12) The photodetector according to (11), further including a second floating diffusion, in which
   the second wiring is electrically coupled to the second floating diffusion.
(13) The photodetector according to any one of (10) to (12), further including:
   a second floating diffusion; and
   a transfer transistor configured to transfer, to the second floating diffusion, electric charge obtained by conversion by the second photoelectric conversion element, in which
   the electric conductor includes wiring electrically coupled to a gate of the transfer transistor.
(14) The photodetector according to any one of (10) to (13), in which
   the second readout circuit includes a selection transistor and a reset transistor, and
   the electric conductor includes wiring electrically coupled to a gate of the selection transistor, or wiring electrically coupled to a gate of the reset transistor.
(15) The photodetector according to any one of (10) to (14), in which
   the first semiconductor layer has the first surface and a second surface on a side opposite to the first surface, and
   the electric conductor is provided to reach at least the second surface of the first semiconductor layer.
(16) A photodetector including:
   a first photoelectric conversion element that photoelectrically converts light;
   a first readout circuit including a first transistor provided on a side of a first surface of a first semiconductor layer, the first readout circuit being configured to output a first signal based on electric charge obtained by conversion by the first photoelectric conversion element;
   a second photoelectric conversion element that photoelectrically converts light;
   a second readout circuit including a second transistor provided next to the first transistor on the side of the first surface of the first semiconductor layer, the second readout circuit being configured to output a second signal based on electric charge obtained by conversion by the second photoelectric conversion element; and
   an insulator provided, in the first semiconductor layer, between the first transistor and the second transistor.
(17) The photodetector according to (16), further including:
   a signal line configured to transmit the first signal; and
   a second floating diffusion, in which
   the first transistor is electrically coupled to the signal line, and
   the second transistor is electrically coupled to the second floating diffusion.
(18) The photodetector according to (16) or (17), further including an insulating film provided around the first transistor and the second transistor, in which
   the insulator has a dielectric constant lower than a dielectric constant of the insulating film.
(19) The photodetector according to any one of (16) to (18), including a second semiconductor layer including the first photoelectric conversion element and the second photoelectric conversion element, in which
   the first semiconductor layer is stacked on the second semiconductor layer.
(20) An electronic apparatus including:
   an optical system; and
   a photodetector that receives light transmitted through the optical system, in which the photodetector includes
      a first photoelectric conversion element that photoelectrically converts light,
      a first readout circuit including a first transistor provided on a side of a first surface of a first semiconductor layer, the first readout circuit being configured to output a first signal based on electric charge obtained by conversion by the first photoelectric conversion element,
      a second photoelectric conversion element that photoelectrically converts light,
      a second readout circuit including a second transistor provided next to the first transistor on the side of the first surface of the first semiconductor layer, the second readout circuit being configured to output a second signal based on electric charge obtained by conversion by the second photoelectric conversion element, and
      an electric conductor provided between the first transistor and the second transistor.

The present application claims the benefit of Japanese Priority Patent Application JP2023-058821 filed with the Japan Patent Office on March 31, 2023, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. A photodetector comprising:
a first photoelectric conversion element that photoelectrically converts light;
a first readout circuit including a first transistor provided on a side of a first surface of a first semiconductor layer, the first readout circuit being configured to output a first signal based on electric charge obtained by conversion by the first photoelectric conversion element;
a second photoelectric conversion element that photoelectrically converts light;
a second readout circuit including a second transistor provided next to the first transistor on the side of the first surface of the first semiconductor layer, the second readout circuit being configured to output a second signal based on electric charge obtained by conversion by the second photoelectric conversion element; and
an electric conductor provided between the first transistor and the second transistor.

2. The photodetector according to claim 1, wherein the electric conductor is provided, in the first semiconductor layer, between the first transistor and the second transistor.

3. The photodetector according to claim 1, further comprising an electrode provided on the side of the first surface of the first semiconductor layer, the electrode being electrically coupled to the electric conductor.

4. The photodetector according to claim 1, comprising a second semiconductor layer including the first photoelectric conversion element and the second photoelectric conversion element, wherein
the first semiconductor layer is stacked on the second semiconductor layer.

5. The photodetector according to claim 1, further comprising a first floating diffusion, wherein
the first transistor is configured to output the first signal based on electric charge accumulated in the first floating diffusion.

6. The photodetector according to claim 1, further comprising a signal line configured to transmit the first signal, wherein
the first transistor includes a first semiconductor region provided on the side of the first surface of the first semiconductor layer, the first semiconductor region being electrically coupled to the signal line, and
the electric conductor is provided between the first semiconductor region and the second transistor.

7. The photodetector according to claim 1, further comprising a second floating diffusion, wherein
the second transistor is electrically coupled to the second floating diffusion.

8. The photodetector according to claim 1, wherein the electric conductor is configured by a semiconductor material doped with an impurity, or by a metal material.

9. The photodetector according to claim 1, wherein
the first readout circuit includes an amplification transistor and the first transistor, the amplification transistor being configured to generate the first signal, the first transistor being configured to output the first signal,
the second readout circuit includes the second transistor and a selection transistor, the second transistor being configured to generate the second signal, the selection transistor being configured to output the second signal,
the amplification transistor, the first transistor, the second transistor, and the selection transistor are provided side by side in a first direction, and
the electric conductor is provided between the first transistor and the second transistor in a plan view.

10. The photodetector according to claim 1, wherein the electric conductor comprises wiring to be supplied with a predetermined potential.

11. The photodetector according to claim 10, further comprising:
first wiring that is electrically coupled to the first transistor; and
second wiring that is electrically coupled to the second transistor, wherein
the first transistor is configured to output the first signal to the first wiring, and
the electric conductor is provided between the first wiring and the second wiring.

12. The photodetector according to claim 11, further comprising a second floating diffusion, wherein
the second wiring is electrically coupled to the second floating diffusion.

13. The photodetector according to claim 10, further comprising:
a second floating diffusion; and
a transfer transistor configured to transfer, to the second floating diffusion, electric charge obtained by conversion by the second photoelectric conversion element, wherein
the electric conductor comprises wiring electrically coupled to a gate of the transfer transistor.

14. The photodetector according to claim 10, wherein
the second readout circuit includes a selection transistor and a reset transistor, and
the electric conductor comprises wiring electrically coupled to a gate of the selection transistor, or wiring electrically coupled to a gate of the reset transistor.

15. The photodetector according to claim 10, wherein
the first semiconductor layer has the first surface and a second surface on a side opposite to the first surface, and
the electric conductor is provided to reach at least the second surface of the first semiconductor layer.

16. A photodetector comprising:
a first photoelectric conversion element that photoelectrically converts light;
a first readout circuit including a first transistor provided on a side of a first surface of a first semiconductor layer, the first readout circuit being configured to output a first signal based on electric charge obtained by conversion by the first photoelectric conversion element;
a second photoelectric conversion element that photoelectrically converts light;
a second readout circuit including a second transistor provided next to the first transistor on the side of the first surface of the first semiconductor layer, the second readout circuit being configured to output a second signal based on electric charge obtained by conversion by the second photoelectric conversion element; and
an insulator provided, in the first semiconductor layer, between the first transistor and the second transistor.

17. The photodetector according to claim 16, further comprising:
a signal line configured to transmit the first signal; and
a second floating diffusion, wherein
the first transistor is electrically coupled to the signal line, and
the second transistor is electrically coupled to the second floating diffusion.

18. The photodetector according to claim 16, further comprising an insulating film provided around the first transistor and the second transistor, wherein
the insulator has a dielectric constant lower than a dielectric constant of the insulating film.

19. The photodetector according to claim 16, comprising a second semiconductor layer including the first photoelectric conversion element and the second photoelectric conversion element, wherein
the first semiconductor layer is stacked on the second semiconductor layer.

20. An electronic apparatus comprising:
an optical system; and
a photodetector that receives light transmitted through the optical system, wherein the photodetector includes
a first photoelectric conversion element that photoelectrically converts light,
a first readout circuit including a first transistor provided on a side of a first surface of a first semiconductor layer, the first readout circuit being configured to output a first signal based on electric charge obtained by conversion by the first photoelectric conversion element,
a second photoelectric conversion element that photoelectrically converts light,
a second readout circuit including a second transistor provided next to the first transistor on the side of the first surface of the first semiconductor layer, the second readout circuit being configured to output a second signal based on electric charge obtained by conversion by the second photoelectric conversion element, and
an electric conductor provided between the first transistor and the second transistor.
